# FASCICULE DE BREVET EUROPEEN

(11) **EP 3 080 813 B1**
(45) Date de publication et mention de la délivrance du brevet: **28.04.2021**
(21) Numéro de dépôt: 14814820.8
(22) Date de dépôt: 12.12.2014
(51) Int. Cl.: G11C 7/10, G11C 13/00, G11C 16/34, G06F 12/02

(54) **SYSTÈME DE GESTION DE L'USURE D'UNE MÉMOIRE ÉLECTRONIQUE**
SYSTEM ZUR VERWALTUNG DES VERSCHLEISSES EINES ELEKTRONISCHEN SPEICHERS
SYSTEM FOR MANAGING THE WEAR OF AN ELECTRONIC MEMORY

(30) Priorité: 12.12.2013 FR 1362470
(43) Date de publication de la demande: 19.10.2016
(73) Titulaire: Commissariat à l'Energie Atomique et aux Energies Alternatives, 75015 Paris (FR)
(72) Inventeur: HARRAND, Michel, F-38120 Saint Egreve (FR); VIANELLO, Elisa, F-38000 Grenoble (FR)
(74) Mandataire: Cabinet Beaumont
(86) Numéro de dépôt international: PCT/EP2014/077652
(87) Numéro de publication internationale: WO 2015/086846

(56) Documents cités:
- WO-A1-2011/119647
- WO-A1-2013/140754
- WO-A2-2011/094218
- US-A1- 2004 022 085
- US-A1- 2004 057 315
- US-A1- 2004 128 433
- US-A1- 2006 227 590
- US-A1- 2010 058 018
- US-A1- 2010 103 723
- US-A1- 2010 274 952
- US-A1- 2011 085 398
- US-A1- 2013 201 748

## Description

La présente demande de brevet revendique la priorité de la demande de brevet français FR13/62470.

### Domaine

La présente demande concerne le domaine des mémoires électroniques de façon générale, et vise plus particulièrement la gestion de l'usure dans une mémoire.

### Exposé de l'art antérieur

Dans la présente demande, on désigne par mémoire, dispositif mémoire, ou mémoire électronique un dispositif comportant une pluralité de cellules élémentaires de mémorisation, chaque cellule pouvant être programmée pour stocker un ou plusieurs bits de données (un bit si l'élément de stockage de la cellule peut prendre deux états distincts, et plusieurs bits si l'élément de stockage de la cellule peut prendre plus de deux états distincts). En pratique, une mémoire peut contenir un très grand nombre de cellules élémentaires, typiquement plusieurs millions à plusieurs centaines de milliards.

On s'intéresse ici plus particulièrement aux mémoires dites résistives, c'est-à-dire dans lesquelles chaque cellule élémentaire de mémorisation comprend un élément dont on peut modifier la résistance en lui appliquant une tension de polarisation. Parmi les mémoires résistives les plus répandues, on peut notamment citer :
les mémoires à changement de phase, généralement désignées dans la technique par l'acronyme PCM (de l'anglais "Phase Change Memory"), dans lesquelles l'élément résistif est réalisé à l'aide d'un matériau dont on peut changer l'état cristallin et par conséquent la résistivité, en faisant varier sa température pendant une écriture ;
les mémoires à pont conducteur, généralement désignées dans la technique par l'acronyme CBRAM (de l'anglais "Conductive Bridge Random Access Memory"), dans lesquelles l'élément résistif est réalisé à l'aide d'un matériau isolant dans lequel un filament conducteur peut être créé ou supprimé par application d'une tension de polarisation ; et
les mémoires à oxydation-réduction, généralement désignées dans la technique par l'acronyme OxRRAM (de l'anglais "Oxyde-based Resistive Random Access Memory"), dans lesquelles l'élément résistif est aussi réalisé à l'aide d'un matériau isolant dans lequel un filament conducteur peut être créé ou supprimé par application d'une tension de polarisation.

Les mémoires résistives sont des mémoires non volatiles, c'est-à-dire qu'elles peuvent conserver les données qu'elles contiennent même en l'absence d'alimentation électrique. Elles présentent en outre de bonnes performances en termes de vitesse et de consommation électrique, par exemple des performances du même ordre de grandeur voire supérieures à celles des mémoires capacitives volatiles désignées dans la technique par le sigle DRAM (de l'anglais "Dynamic Random Access Memory"), qui sont largement utilisées dans de nombreux systèmes électroniques. De plus, les mémoires résistives présentent un encombrement relativement faible, et notamment inférieur à celui des mémoires DRAM (à capacité de stockage de données identique).

Dans de nombreux systèmes électroniques, il serait avantageux de pouvoir remplacer des mémoires de type DRAM par des mémoires résistives, pour tirer profit notamment de la non volatilité et de la densité élevée des mémoires résistives.

Toutefois, un problème qui se pose est que les cellules élémentaires des mémoires résistives ont une durée de vie ou endurance relativement faible par rapport aux mémoires DRAM. A titre d'exemple illustratif, le nombre maximum de cycles, c'est-à-dire le nombre maximum de lectures ou écritures, que peut typiquement supporter une cellule élémentaire d'une mémoire résistive est de l'ordre de 10⁸, alors que ce nombre est quasiment infini pour une mémoire DRAM.

Ainsi, pour pouvoir utiliser des mémoires résistives dans des applications mettant en oeuvre des accès fréquents à la mémoire, par exemple comme mémoire vive dans un ordinateur, une tablette numérique, un smartphone, etc., il convient de prévoir des mécanismes de contrôle de l'usure de la mémoire, permettant d'augmenter sa durée de vie.

Les documents US2004/057315, US2004/128433, US2010/274952 et WO2011/094218 décrivent des exemples de systèmes comportant des mémoires électroniques.

### Résumé

La présente invention est définie par la revendication indépendante 1. Des aspects préférentiels sont définis dans les revendications dépendantes 2 à 17.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente de façon schématique un exemple d'organisation ou d'agencement de cellules élémentaires de stockage de données dans une mémoire ;
les figures 2A à 2F illustrent de façon schématique des exemples de mécanismes ou procédés de gestion de l'usure d'une mémoire ;
la figure 3 représente de façon schématique un exemple de réalisation d'un dispositif d'adressage d'une mémoire susceptible d'être utilisé dans un système mettant en oeuvre des procédés de gestion d'usure du type décrit en relation avec les figures 2A à 2F ;
la figure 4 représente de façon schématique et partielle un exemple de réalisation d'une mémoire permettant des accès simultanés à des données contenues dans des portions distinctes de la mémoire ;
la figure 5 représente de façon schématique et partielle un autre exemple de réalisation d'une mémoire permettant des accès simultanés à des données contenues dans des portions distinctes de la mémoire ;
la figure 6 représente de façon schématique et partielle un exemple d'un mode de réalisation d'un système comportant une mémoire et des moyens de mise en oeuvre d'un procédé de gestion de l'usure de cette mémoire ; et
la figure 7 représente de façon schématique et partielle un autre exemple d'un mode de réalisation d'un système comportant une mémoire et des moyens de mise en oeuvre d'un procédé de gestion de l'usure de cette mémoire.

### Description détaillée

Par souci de clarté, de mêmes éléments ont été désignés par de mêmes références aux différentes figures. En outre, seuls les éléments utiles à la compréhension des modes de réalisation décrits ont été représentés et seront détaillés par la suite. En particulier, des modes de réalisation de systèmes comportant une mémoire et des moyens de mise en oeuvre de procédés de gestion de l'usure de cette mémoire ont été représentés et seront détaillés. Toutefois, les diverses utilisations qui peuvent être faites de la mémoire de tels systèmes n'ont pas été détaillées, les modes de réalisation décrits étant compatibles avec les utilisations usuelles d'une mémoire.

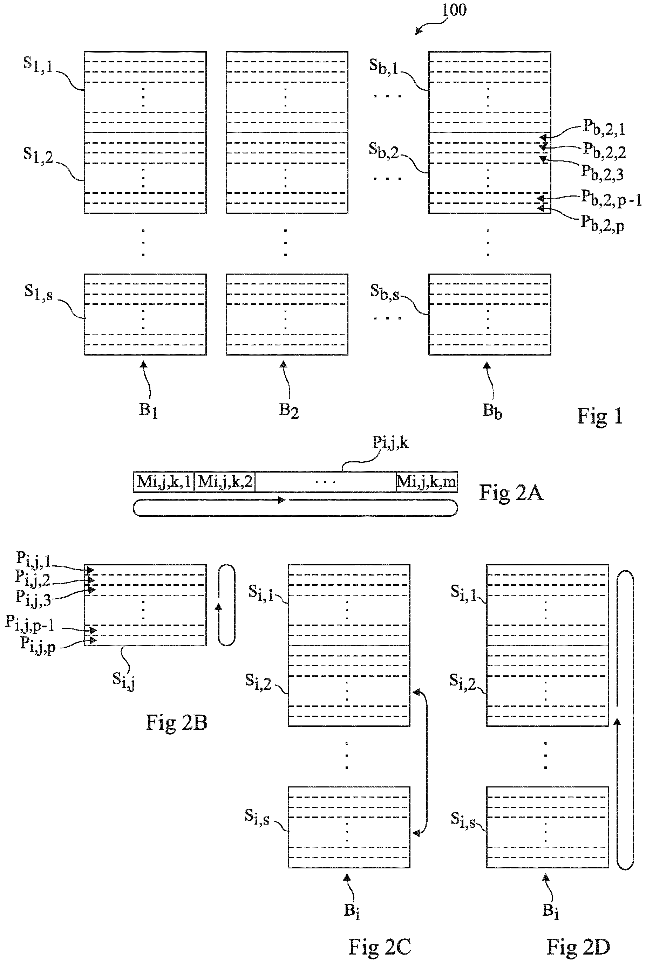

La figure 1 représente de façon schématique un exemple d'agencement de cellules élémentaires de stockage de données (non visibles sur la figure) dans une mémoire 100, par exemple une mémoire résistive. Dans cet exemple, les cellules élémentaires de la mémoire 100 sont réparties en plusieurs bancs Bᵢ, avec i entier allant de 1 à b et b entier supérieur à 1, les cellules de chaque banc Bᵢ sont réparties en plusieurs segments S_{i,j}, avec j entier allant de 1 à s et s entier supérieur à 1, les cellules de chaque segment S_{i,j} sont réparties en plusieurs lignes ou pages P_{i,j,k}, avec k entier allant de 1 à p et p entier supérieur à 1, et les cellules de chaque page P_{i,j,k} sont réparties en plusieurs mots M_{i,j,k,l}, avec l entier allant de 1 à m et m entier supérieur à 1, de plusieurs cellules élémentaires chacun. Chaque page P_{i,j,k} correspond par exemple à la plus grande quantité de mémoire adressable en un seul cycle mémoire, c'est-à-dire le plus grand groupe de cellules élémentaires qui peut être lu ou écrit en un seul cycle dans la mémoire. A titre d'exemple illustratif non limitatif, la mémoire 100 est une mémoire de 32 Giga-bits, organisée en 32 bancs comportant chacun 512 segments, chaque segment comportant 4096 pages comportant chacune 16 mots de 32 cellules élémentaires (32 bits).

En pratique, dans la plupart des systèmes électroniques utilisant une mémoire, la répartition des accès en lecture et/ou en écriture à l'intérieur de la mémoire est très inégale. En effet, certaines données stockées dans la mémoire sont utilisées beaucoup plus fréquemment que d'autres. Les portions de mémoire contenant les données les plus fréquemment utilisées s'usent plus rapidement que les autres, et leur durée de vie conditionne généralement la durée de vie de l'intégralité de la mémoire.

Pour augmenter la durée de vie d'une mémoire, on peut prévoir, lorsqu'une portion de la mémoire a été écrite plus d'un certain nombre de fois, de déplacer les données contenues dans cette portion de la mémoire soit à l'intérieur de la portion elle-même, soit vers une autre portion de la mémoire. De tels déplacements de données permettent de mieux répartir les accès aux cellules physiques de la mémoire, et ainsi d'équilibrer l'usure de la mémoire et donc d'augmenter sa durée de vie. Pour que ces déplacements de données soient transparents pour l'utilisateur de la mémoire, on peut prévoir un dispositif de conversion d'adresses dites logiques ou adresses utilisateur, qui sont les adresses dont se sert l'utilisateur pour accéder à la mémoire, en adresses dites physiques, qui sont les adresses où sont effectivement physiquement mémorisées les données sur lesquelles pointent les adresses utilisateur.

La figure 2A illustre schématiquement un premier exemple de procédé de gestion ou d'équilibrage d'usure qui peut être mis en oeuvre dans la mémoire 100 de la figure 1.

Dans cet exemple, les accès à chaque page P_{i,j,k} de la mémoire sont comptés, et, lorsque le nombre d'accès à une page P_{i,j,k} de la mémoire dépasse un seuil, une rotation circulaire interne des données de cette page est mise en oeuvre, c'est-à-dire que les contenus des mots M_{i,j,k,l} de la page subissent une rotation circulaire à l'intérieur de la page. A titre d'exemple, le contenu du premier mot M_{i,j,k,1} de la page est transféré dans le deuxième mot M_{i,jk,2} de la page, le contenu du deuxième mot M_{i,j,k,2} de la page est transféré dans le troisième mot M_{i,j,k,3} de la page, et ainsi de suite jusqu'au dernier mot M_{i,j,k,m} de la page dont le contenu est transféré dans le premier mot M_{i,j,k,1} de la page.

La figure 2B illustre schématiquement un deuxième exemple de procédé de gestion ou d'équilibrage d'usure qui peut être mis en oeuvre dans la mémoire 100 de la figure 1.

Dans cet exemple, après un certain nombre d'accès à un segment S_{i,j} de la mémoire, une rotation circulaire interne des données de ce segment est mise en oeuvre, c'est-à-dire que les contenus des pages P_{i,j,k} du segment subissent une rotation circulaire à l'intérieur du segment. A titre d'exemple, le contenu de la première page P_{i,j,1} du segment est transféré dans la deuxième page P_{i,j,2} du segment, le contenu de la deuxième page P_{i,j,2} du segment est transféré dans la troisième page P_{i,j,3} du segment, et ainsi de suite jusqu'à la dernière page P_{i,j,p} du segment dont le contenu est transféré dans la première page P_{i,j,1} du segment.

A titre d'exemple, les accès à chaque segment S_{i,j} de la mémoire peuvent être comptés, et, lorsque le nombre d'accès à un segment S_{i,j} de la mémoire dépasse un seuil, une rotation circulaire interne peut être appliquée à ce segment. A titre de variante, si le procédé de la figure 2A est mis en oeuvre, une rotation circulaire interne peut être appliquée à un segment S_{i,j} lorsqu'une même page de ce segment a subi un certain nombre de rotations circulaires internes, par exemple égal au nombre de mots de la page, c'est-à-dire lorsque le contenu de chaque mot M_{i,j,k,l} de la page a retrouvé l'emplacement physique qu'il occupait avant la première rotation circulaire interne de la page.

La figure 2C illustre schématiquement un troisième exemple de procédé de gestion ou d'équilibrage d'usure qui peut être mis en oeuvre dans la mémoire 100 de la figure 1.

Dans cet exemple, après un certain nombre d'accès à un segment S_{i,j} de la mémoire, le contenu de ce segment est permuté avec le contenu d'un autre segment du même banc Bᵢ de la mémoire, par exemple un segment ayant subi un nombre d'accès moins important, par exemple le segment du banc Bᵢ ayant subi le nombre d'accès le plus faible.

A titre d'exemple, les accès à chaque segment S_{i,j} de la mémoire peuvent être comptés, et, lorsque le nombre d'accès à un segment S_{i,j} de la mémoire dépasse un seuil, une permutation du contenu de ce segment avec le contenu d'un autre segment du même banc peut être effectuée. A titre de variante, si le procédé de la figure 2B est mis en oeuvre, une permutation du contenu d'un segment S_{i,j} avec le contenu d'un autre segment du même banc peut être effectuée lorsque le segment S_{i,j} a subi un certain nombre de rotations circulaires internes, par exemple égal au nombre de pages de ce segment.

La figure 2D illustre schématiquement un quatrième exemple de procédé de gestion ou d'équilibrage d'usure qui peut être mis en oeuvre dans la mémoire 100 de la figure 1.

Dans cet exemple, après un certain nombre d'accès à un banc Bᵢ de la mémoire, une rotation circulaire interne des données de ce banc est mise en oeuvre, c'est-à-dire que les segments S_{i,j} du banc subissent une rotation circulaire à l'intérieur du banc. A titre d'exemple, le contenu du premier segment S_{i,1} du banc est transféré dans le deuxième segment S_{i,2} du banc, le contenu du deuxième segment S_{i,2} du banc est transféré dans le troisième segment S_{i,3} du banc, et ainsi de suite jusqu'au dernier segment S_{i,s} du banc dont le contenu est transféré dans le premier segment S_{i,1} du banc.

A titre d'exemple, les accès à chaque banc Bᵢ de la mémoire peuvent être comptés, et, lorsque le nombre d'accès à un banc Bᵢ de la mémoire dépasse un seuil, ce banc peut subir une rotation circulaire interne. A titre de variante, si le procédé de la figure 2B est mis en oeuvre à l'intérieur des segments de la mémoire, un banc Bᵢ peut subir une rotation circulaire interne lorsqu'un même segment S_{i,j} de ce banc a subi un certain nombre de rotations circulaires internes, par exemple égal au nombre de pages de ce segment.

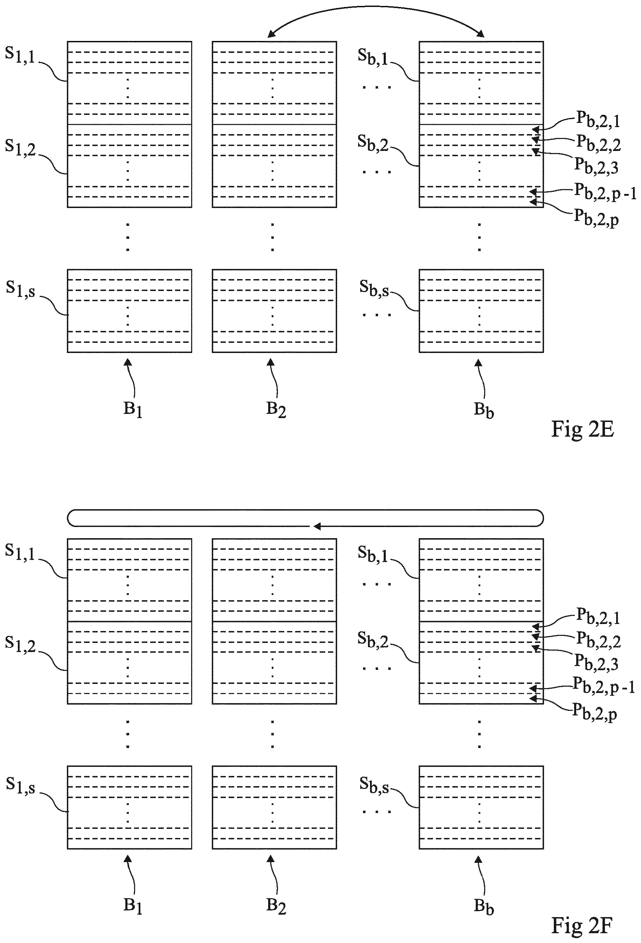

La figure 2E illustre schématiquement un cinquième exemple de procédé de gestion ou d'équilibrage d'usure qui peut être mis en oeuvre dans la mémoire 100 de la figure 1.

Dans cet exemple, après un certain nombre d'accès à un banc Bᵢ de la mémoire, le contenu de ce banc est permuté avec le contenu d'un autre banc de la mémoire, par exemple un banc ayant subi un nombre d'accès moins important, par exemple le banc de la mémoire ayant subi le nombre d'accès le plus faible.

A titre d'exemple, les accès à chaque banc de la mémoire peuvent être comptés, et, lorsque le nombre d'accès à un banc Bᵢ de la mémoire dépasse un seuil, une permutation du contenu de ce banc avec le contenu d'un autre banc de la mémoire peut être effectuée. A titre de variante, si le procédé de la figure 2C ou le procédé de la figure 2D est mis en oeuvre, une permutation du contenu d'un banc Bᵢ avec le contenu d'un autre banc peut être effectuée lorsque le banc Bᵢ a subi un certain nombre de permutations internes de segments (figure 2C) ou de rotations circulaires internes (figure 2D), par exemple égal au nombre de segments du banc.

La figure 2F illustre schématiquement un sixième exemple de procédé de gestion ou d'équilibrage d'usure qui peut être mis en oeuvre dans la mémoire 100 de la figure 1.

Dans cet exemple, après un certain nombre d'accès à la mémoire, une rotation circulaire interne des données de la mémoire est mise en oeuvre, c'est-à-dire que les bancs Bᵢ subissent une rotation circulaire à l'intérieur de la mémoire. A titre d'exemple, le contenu du premier banc B₁ est transféré dans le deuxième banc B₂, le contenu du deuxième banc B₂ est transféré dans le troisième banc B₃, et ainsi de suite jusqu'au dernier banc B_{b} dont le contenu est transféré dans le premier banc B₁.

A titre d'exemple, les accès à la mémoire peuvent être comptés, et, lorsque le nombre d'accès à la mémoire dépasse un seuil, la mémoire peut subir une rotation circulaire interne. A titre de variante, si le procédé de la figure 2C ou le procédé de la figure 2D est mis en oeuvre, une rotation circulaire interne de la mémoire peut être effectuée lorsqu'un même banc Bᵢ de la mémoire a subi un certain nombre de permutations internes de segments (figure 2C) ou de rotations circulaires internes (figure 2D), par exemple égal au nombre de segments du banc.

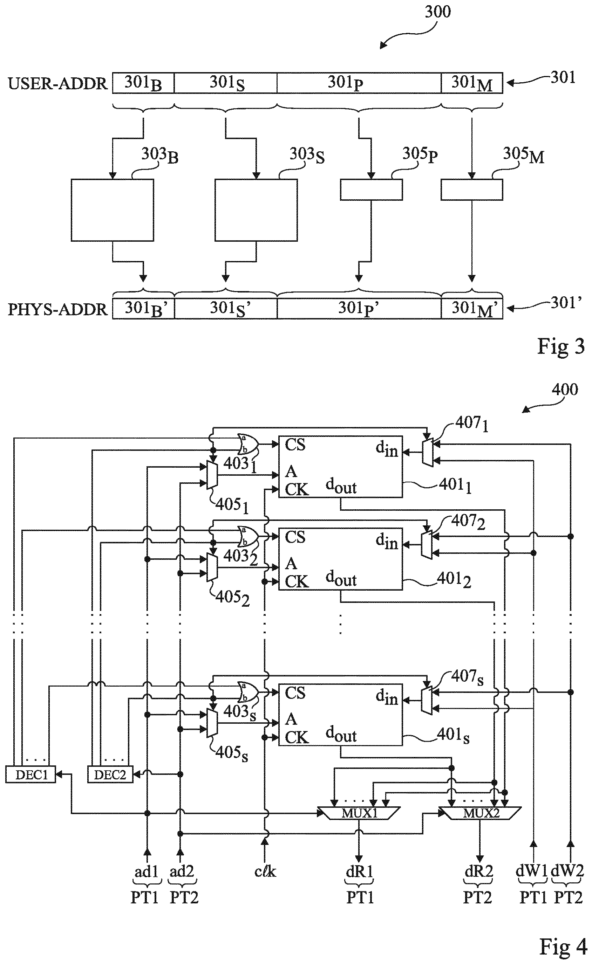

La figure 3 représente de façon schématique un exemple de réalisation d'un dispositif 300 permettant, lorsqu'un procédé de gestion d'usure du type décrit en relation avec les figures 2A à 2F est mis en oeuvre dans la mémoire 100 de la figure 1, de convertir des adresses logiques ou adresses utilisateur, qui sont les adresses utilisées par l'utilisateur pour accéder à des données dans la mémoire, en adresses dites physiques, qui sont les adresses où sont effectivement physiquement mémorisées les données dans la mémoire. Le dispositif 300 permet notamment, lorsqu'un utilisateur accède à la mémoire par son intermédiaire, de rendre transparents pour l'utilisateur les déplacements de données internes à la mémoire qui résultent du procédé d'équilibrage d'usure.

Dans l'exemple de la figure 3, on considère, à titre d'exemple illustratif non limitatif, le cas où le procédé d'équilibrage d'usure met en oeuvre les mécanismes des figures 2A, 2B, 2C et 2E.

Le dispositif 300 est adapté à recevoir une adresse utilisateur 301 (USER-ADDR) pointant sur un mot de la mémoire 100 visé par l'utilisateur, et à fournir une adresse physique 301' (PHYS-ADDR), correspondant à l'adresse réelle à laquelle le contenu du mot visé est effectivement mémorisé.

L'adresse utilisateur 301 comprend un premier sous-ensemble de bits 301_{B} définissant l'adresse du banc dans lequel, pour l'utilisateur, le contenu visé est supposé se trouver, c'est-à-dire l'adresse du banc dans lequel le contenu visé se trouverait effectivement si le procédé d'équilibrage d'usure n'était pas mis en oeuvre. L'adresse utilisateur 301 comprend en outre un deuxième sous-ensemble de bits 301_{S} définissant, à l'intérieur d'un banc, l'adresse du segment dans lequel, pour l'utilisateur, le contenu visé est supposé se trouver, un troisième sous-ensemble de bits 301p définissant, à l'intérieur d'un segment, l'adresse de la page dans laquelle, pour l'utilisateur, le contenu visé est supposé se trouver, et un quatrième sous-ensemble de bits 301_{M} définissant, à l'intérieur d'une page, l'adresse du mot dans lequel, pour l'utilisateur, le contenu visé est supposé se trouver.

L'adresse physique 301' comprend un premier sous-ensemble de bits 301_{B}' définissant l'adresse du banc dans lequel se trouve effectivement le contenu du mot visé par l'utilisateur. L'adresse physique 301' comprend en outre un deuxième sous-ensemble de bits 301_{S}' définissant, à l'intérieur du banc, l'adresse du segment dans lequel se trouve effectivement le contenu recherché, un troisième sous-ensemble de bits 301p' définissant, à l'intérieur du segment, l'adresse de la page dans laquelle se trouve effectivement le contenu recherché, et un quatrième sous-ensemble de bits 301_{M}' définissant, à l'intérieur de la page, l'adresse du mot dans lequel se trouve effectivement le contenu recherché.

Le dispositif 300 comprend un premier élément de conversion 303_{B}, adapté à convertir l'adresse utilisateur de banc 301_{B} en l'adresse physique de banc 301_{B}'. Dans cet exemple, l'élément de conversion 303_{B} comprend une table de traduction d'adresses de banc comportant b entrées de log2(b) bits chacune, b étant le nombre de bancs de la mémoire. A chaque permutation de bancs lors de la mise en oeuvre du procédé d'équilibrage d'usure de la figure 2E, les nouvelles adresses physiques 301_{B}' des contenus permutés sont mises à jour dans la table.

Le dispositif 300 comprend en outre un deuxième élément de conversion 303_{S}, adapté à convertir l'adresse utilisateur de segment 301_{S} en l'adresse physique de segment 301_{S}'. Dans cet exemple, l'élément de conversion 303_{S} comprend, pour chaque banc de la mémoire, une table de traduction d'adresses de segment comportant s entrées de log2(s) bits chacune, s étant le nombre de segments du banc. A chaque permutation de segments lors de la mise en oeuvre du procédé d'équilibrage d'usure de la figure 2C, les nouvelles adresses physiques 301_{S}' des contenus permutés sont mises à jour dans la table correspondante.

Le dispositif 300 comprend en outre un troisième élément de conversion 305p, adapté à convertir l'adresse utilisateur de page 301p en l'adresse physique de page 301p'. Dans cet exemple, l'élément de conversion 305p comprend, pour chaque segment de la mémoire, un registre de suivi de décalages, contenant le nombre de rotations circulaires internes subies par le segment lors de la mise en oeuvre du procédé d'équilibrage d'usure de la figure 2B. Pour déterminer l'adresse physique 301p' de la page recherchée, le dispositif 300 peut ajouter à l'adresse utilisateur de page 301p la valeur contenue dans le registre de suivi de décalages du segment, modulo p, où p est le nombre de pages du segment.

Le dispositif 300 comprend en outre un quatrième élément de conversion 305_{M}, adapté à convertir l'adresse utilisateur de mot 301_{M} en l'adresse physique de mot 301_{M}'. Dans cet exemple, l'élément de conversion 305p comprend, pour chaque page de la mémoire, un registre de suivi de décalages, contenant le nombre de rotations circulaires internes subies par la page lors de la mise en oeuvre du procédé d'équilibrage d'usure de la figure 2A. Pour déterminer l'adresse physique 301_{M}' du mot recherché, le dispositif 300 peut ajouter à l'adresse utilisateur de mot 301_{M} la valeur contenue dans le registre de suivi de décalages la page, modulo m, où m est le nombre de mots de la page.

Les modes de réalisation décrits dans la présente demande ne se limitent pas à l'exemple particulier de dispositif de conversion d'adresses de la figure 3. Plus généralement, quels que soient les déplacements de contenus mis en oeuvre dans une mémoire pour équilibrer son usure, on peut prévoir un dispositif de conversion d'adresses permettant de convertir des adresses utilisateurs en adresses physiques, par exemple en utilisant des tables de traduction d'adresses et/ou des registres de suivi de décalages.

Il serait souhaitable de pouvoir mettre en oeuvre un procédé de gestion ou d'équilibrage d'usure impliquant des déplacements de contenus à l'intérieur de la mémoire, par exemple des procédés du type décrit en relation avec les figures 2A à 2F, sans que cela n'entraine d'interruption de service pour l'utilisateur de la mémoire, c'est-à-dire sans que l'accès à la mémoire ne soit bloqué pour l'utilisateur pendant les phases de déplacement de données du procédé de gestion d'usure.

En effet, à titre d'exemple illustratif, la permutation du contenu de deux segments de la mémoire 100 de la figure 1 requiert 2*p opérations de lecture et 2*p opérations d'écriture, où p est le nombre de pages dans un segment. Si on considère l'exemple numérique susmentionné d'une mémoire comportant 4096 pages par segment, et si on considère une mémoire présentant un temps d'accès en lecture de page de 50 ns et un temps d'accès en écriture de page de 50 ns, le temps requis pour permuter le contenu de deux segments peut être de l'ordre de 2*2*4096*50 ns = 819 µs. Dans de nombreuses applications, bloquer l'accès à la mémoire sans interruption pendant une telle durée pose problème.

Selon un aspect des modes de réalisation décrits, on prévoit un système comportant une mémoire comportant plusieurs portions de plusieurs pages chacune, cette mémoire comportant deux ports permettant d'accéder simultanément, en lecture, en écriture, ou en lecture et en écriture, à deux pages de portions distinctes de la mémoire. Ce système comprend un circuit de contrôle adapté à mettre en oeuvre, via un seul des deux ports d'accès de la mémoire, un procédé de gestion de l'usure de la mémoire, comportant des permutations de contenu à l'intérieur d'une même portion ou entre des portions distinctes de la mémoire, par exemple un procédé du type décrit en relation avec les figures 2A à 2F. Le circuit de contrôle est configuré pour permettre à tout moment à l'utilisateur d'accéder au contenu de la mémoire via l'autre port d'accès de la mémoire, y compris pendant les phases de permutation de contenus du procédé de gestion d'usure.

La figure 4 représente de façon schématique et partielle un exemple de réalisation d'une mémoire 400 comportant une pluralité de portions de mémoire 401ⱼ, avec j entier allant de 1 à s et s entier supérieur à 1, de plusieurs pages chacune. La mémoire 400 comporte deux ports d'accès PT1 et PT2 permettant d'accéder simultanément à deux pages quelconques de la mémoire 400, à condition que ces pages appartiennent à des portions 401ⱼ distinctes de la mémoire.

Par port d'accès, on entend ici un ensemble de bornes d'entrée et/ou sortie adapté à recevoir un signal d'adresse, à recevoir un signal de donnée d'entrée, et/ou à fournir un signal de donnée de sortie. Un port d'accès peut notamment comporter une entrée d'adresse sur plusieurs bits, adaptée à recevoir un signal d'adresse d'une page de la mémoire, une entrée de donnée sur plusieurs bits, adaptée à recevoir un signal de donnée à écrire dans une page de la mémoire, et une sortie de donnée sur plusieurs bits, adaptée à fournir un signal de donnée lue dans une page de la mémoire. L'entrée de donnée et la sortie de donnée peuvent éventuellement être confondues. Dans l'exemple de la figure 4, le port d'accès PT1 de la mémoire 400 comporte une entrée d'adresse ad1, une entrée de donnée dW1, et une sortie de donnée dR1, et le port d'accès PT2 comporte une entrée d'adresse ad2, une entrée de donnée dW2, et une sortie de donnée dR2.

Chaque portion 401j de la mémoire 400 est constituée par un circuit comportant une pluralité de cellules élémentaires de mémorisation (non représentées), par exemple des cellules de mémorisation résistives, réparties en plusieurs pages de plusieurs cellules chacune. Dans cet exemple, chaque portion de mémoire 401ⱼ comprend une entrée CS adaptée à recevoir un signal d'activation/désactivation de la portion 401ⱼ, une entrée CK adaptée à recevoir un signal d'horloge, une entrée A adaptée à recevoir une adresse d'une page de la portion de mémoire 401ⱼ, une entrée dᵢₙ adaptée à recevoir une donnée à écrire dans la page d'adresse A de la portion de mémoire 401ⱼ, et une sortie dₒᵤₜ adaptée à fournir une donnée lue dans la page d'adresse A de la portion de mémoire 401ⱼ.

Dans cet exemple, chaque portion 401ⱼ de la mémoire 400 a son entrée d'activation CS reliée à la sortie d'une porte OU 403ⱼ à deux entrées a et b. La mémoire 400 comprend un premier circuit de décodage d'adresse DEC1, comprenant une entrée reliée à l'entrée d'adresse ad1 du port d'accès PT1 de la mémoire et s sorties binaires reliées respectivement aux entrées a des portes OU 403₁ à 403ₛ. La mémoire 400 comprend en outre un second circuit de décodage d'adresse DEC2, comprenant une entrée reliée à l'entrée d'adresse ad2 du port d'accès PT2 de la mémoire et s sorties binaires reliés respectivement aux entrées b des portes OU 403₁ à 403ₛ. Le décodeur DEC1 est adapté à déterminer dans quelle portion 401ⱼ de la mémoire 400 se trouve la page adressée par l'entrée d'adresse ad1, et à appliquer un signal d'activation sur l'entrée a de la porte OU 403ⱼ reliée à cette portion de mémoire. Le décodeur DEC2 est adapté à déterminer dans quelle portion 401ⱼ de la mémoire 400 se trouve la page adressée par l'entrée d'adresse ad2, et à appliquer un signal d'activation sur l'entrée b de la porte OU 403ⱼ reliée à cette portion de mémoire. Ainsi, les décodeurs DEC1 et DEC2 peuvent activer simultanément deux portions de mémoire 401ⱼ distinctes. En pratique, parmi les bits d'adresse appliqués sur les entrées ad1 et ad2, on peut se contenter de transmettre aux décodeurs DEC1 et DEC2 uniquement les bits indiquant les numéros des portions de mémoire dans lesquelles se trouvent les pages adressées.

Dans cet exemple, chaque portion 401ⱼ de la mémoire 400 a son entrée d'adressage A reliée à la sortie d'un multiplexeur 405j de deux entrées vers une sortie, et son entrée de donnée dᵢₙ reliée à la sortie d'un multiplexeur 407ⱼ de deux entrées vers une sortie. Chaque multiplexeur 405ⱼ a une première entrée reliée à l'entrée d'adresse ad1 du port PT1 et une deuxième entrée reliée à l'entrée d'adresse ad2 du port PT2, et chaque multiplexeur 407ⱼ a une première entrée reliée à l'entrée de donnée dW1 du port PT1 et une deuxième entrée reliée à l'entrée de donnée dW2 du port PT2. Dans cet exemple, chaque multiplexeur 405ⱼ a de plus une entrée de sélection reliée à l'entrée b de la porte OU 403ⱼ reliée à la portion de mémoire 401ⱼ, et chaque multiplexeur 407ⱼ a une entrée de sélection reliée à l'entrée b de la porte OU 403ⱼ. Le fonctionnement des multiplexeurs 405ⱼ et 407ⱼ est tel que : lorsqu'une portion de mémoire 401ⱼ est activée par le décodeur DEC1, l'adresse fournie par le multiplexeur 405ⱼ sur l'entrée A de la portion de mémoire 401ⱼ est celle transmise par l'entrée d'adresse ad1, et la donnée fournie par le multiplexeur 407ⱼ sur l'entrée dᵢₙ de la portion de mémoire 401ⱼ est celle transmise par l'entrée de donnée dW1 ; et lorsqu'une portion de mémoire 401ⱼ est activée par le décodeur DEC2, l'adresse fournie par le multiplexeur 405ⱼ sur l'entrée A de la portion de mémoire 401ⱼ est celle transmise par l'entrée d'adresse ad2, et la donnée fournie par le multiplexeur 407ⱼ sur l'entrée dᵢₙ de la portion de mémoire 401ⱼ est celle transmise par l'entrée de donnée dW2. En pratique, parmi les bits d'adresse transmis par les entrée d'adresse ad1 et ad2, on peut se contenter de transmettre aux multiplexeurs 405ⱼ uniquement les bits définissant la position de la page adressée à l'intérieur de la portion de mémoire 401ⱼ dans laquelle elle se trouve.

Dans cet exemple, la mémoire 400 comprend en outre un premier multiplexeur MUX1 de s entrées vers une sortie, dont la sortie est reliée à la sortie de donnée dR1 du port PT1, et un second multiplexeur MUX2 de s entrées vers une sortie, dont la sortie est reliée à la sortie de donnée dR2 du port PT2. Les s entrées du multiplexeur MUX1 sont reliées respectivement aux s sorties de donnée dₒᵤₜ des s portions 401ⱼ de la mémoire 400. De même, les s entrées du multiplexeur MUX2 sont reliés respectivement aux s sorties de donnée dₒᵤₜ des s portions 401ⱼ de la mémoire 400. Dans cet exemple, le multiplexeur MUX1 a une entrée de commande ou de sélection reliée à l'entrée d'adresse ad1 du port d'accès PT1 de la mémoire, et le multiplexeur MUX2 a une entrée de commande ou de sélection reliée à l'entrée d'adresse ad2 du port d'accès PT2 de la mémoire. Le fonctionnement des multiplexeurs MUX1 et MUX2 est tel que : lorsqu'une portion de mémoire 401ⱼ est activée par le décodeur DEC1, la donnée fournie par le multiplexeur MUX1 sur la sortie de donnée dR1 est celle fournie par la portion de mémoire 401ⱼ sur sa sortie dₒᵤₜ ; et lorsqu'une portion de mémoire 401ⱼ est activée par le décodeur DEC2, la donnée fournie par le multiplexeur MUX2 sur la sortie de donnée dR2 est celle fournie par la portion de mémoire 401ⱼ sur sa sortie dₒᵤₜ. En pratique, parmi les bits d'adresse appliqués sur les entrées ad1 et ad2, on peut se contenter de transmettre aux multiplexeurs MUX1 et MUX2 uniquement les bits indiquant les numéros des portions de mémoire dans lesquelles se trouvent les pages adressées.

Dans cet exemple, les entrées CK des différentes portions 401ⱼ de la mémoire 400 sont reliées à un même noeud clk d'application d'un signal d'horloge.

A titre d'exemple, les différentes portions 401ⱼ de la mémoire 400, et les éléments 403ⱼ, 405ⱼ, 407ⱼ, DEC1, DEC2, MUX1 et MUX2 peuvent être intégrés dans une même puce semiconductrice.

Un avantage de la mémoire 400 est qu'elle permet des accès simultanés en lecture, en écriture, ou en lecture et en écriture, à des pages distinctes de la mémoire, tout en présentant un encombrement à peine supérieur à celui d'une mémoire simple port.

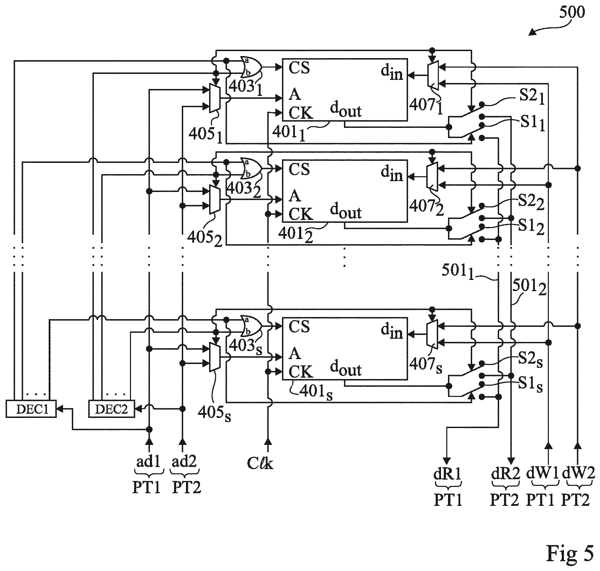

La figure 5 représente de façon schématique et partielle une mémoire 500 correspondant à une variante de réalisation de la mémoire 400 de la figure 4. La mémoire 500 de la figure 5 comprend de nombreux éléments communs avec la mémoire 400 de la figure 4. Ces éléments ne seront pas à nouveau décrits en détail ci-après. Dans la suite, seules les différences entre les mémoires 400 et 500 seront mises en exergue.

La mémoire 500 comprend, comme dans l'exemple de la figure 4, un premier port d'accès PT1 comportant une entrée d'adresse ad1, une entrée de donnée dW1, et une sortie de donnée dR1, et un second port d'accès PT2 comportant une entrée d'adresse ad2, une entrée de donnée dW2, et une sortie de donnée dR2.

De plus, la mémoire 500 comprend une pluralité de portions de mémoire 401ⱼ, avec j entier allant de 1 à s et s entier supérieur à 1, identiques ou similaires à celles de la mémoire 400 de la figure 4.

Dans la mémoire 500, les mécanismes de sélection des portions 401ⱼ, via les décodeurs DEC1 et DEC2 et les portes OU 403ⱼ, les mécanismes d'adressage de page dans les portions 401ⱼ, via les multiplexeurs 405ⱼ, et les mécanismes de fourniture de données d'entrée aux portions 401ⱼ, via les multiplexeurs 407ⱼ, sont identiques ou similaires à ceux de la mémoire 400 de la figure 4, et ne seront pas décrits à nouveau.

La mémoire 500 de la figure 5 diffère de la mémoire 400 de la figure 4 principalement par les circuits utilisés pour multiplexer les sorties de donnée dₒᵤₜ des différentes portions de mémoire 401ⱼ, vers les sorties de donnée dR1 et dR2 des ports PT1 et PT2 respectivement. Dans la mémoire 500, chaque portion 401j de la mémoire a sa sortie dₒᵤₜ reliée, par un premier interrupteur S1ⱼ, à un bus de donnée de sortie 501₁ relié à la sortie de donnée dR1 de la mémoire, et, par un second interrupteur S2ⱼ, à un bus de donnée de sortie 501₂ relié à la sortie de donnée dR1 de la mémoire. Dans cet exemple, chaque interrupteur S1ⱼ a un noeud de commande connecté à l'entrée a de la porte OU 403ⱼ reliée à la portion de mémoire 401ⱼ, et chaque interrupteur S2ⱼ a un noeud de commande connecté à l'entrée b de la porte OU 403ⱼ. Lorsqu'une portion de mémoire 401ⱼ est activée par le décodeur DEC1, la sortie de donnée dₒᵤₜ de la portion de mémoire 401ⱼ est reliée à la sortie de donnée dR1 de la mémoire par fermeture de l'interrupteur S1ⱼ, et lorsqu'une portion de mémoire 401ⱼ est activée par le décodeur DEC2, la sortie de donnée dₒᵤₜ de la portion de mémoire 401ⱼ est reliée à la sortie de donnée dR2 de la mémoire par fermeture de l'interrupteur S2ⱼ.

Ainsi, dans la mémoire 500, les multiplexeurs MUX1 et MUX2 de la figure 4 sont remplacés par un circuit de multiplexage distribué, réparti au niveau des différentes portions de mémoire 401j. Les interrupteurs S1ⱼ et S2ⱼ sont par exemple réalisés par des transistors MOS. Chaque couple d'interrupteurs S1ⱼ, S2ⱼ est par exemple disposé au voisinage de la portion de mémoire 401ⱼ correspondante. De plus, les bus de donnée de sortie 501₁ et 501₂ passent de préférence à proximité des différentes portions de mémoire 401ⱼ.

Un avantage de la variante de réalisation de la figure 5 est qu'elle permet, par rapport à l'exemple de la figure 4, de réduire le nombre de câbles ou pistes reliant les sorties dₒᵤₜ des différentes portions de mémoire 401ⱼ aux sorties de donnée dR1 et dR2 de la mémoire (et donc de réduire la surface et le coût de la mémoire).

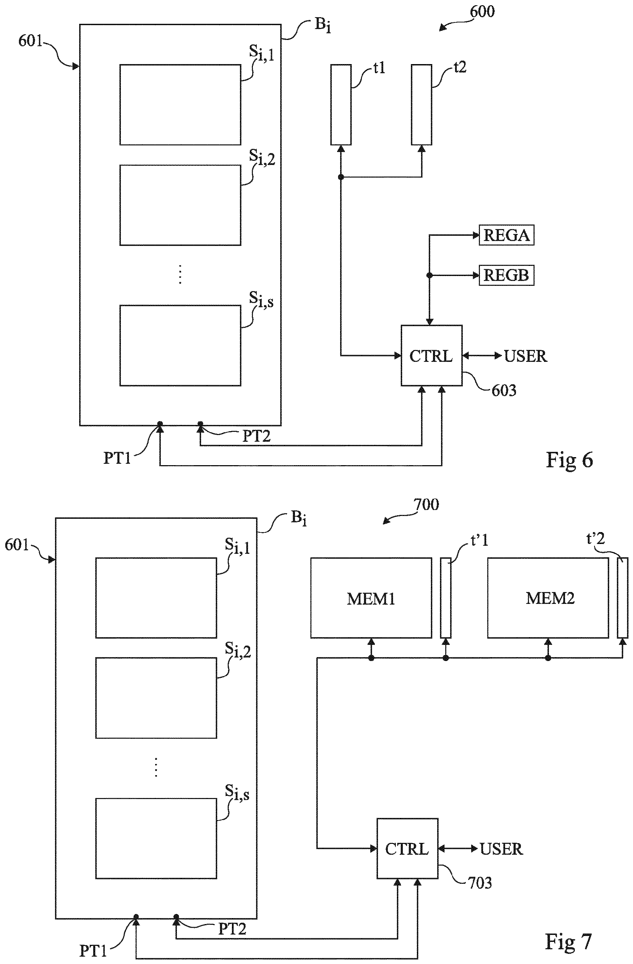

La figure 6 représente de façon schématique et partielle un exemple d'un mode de réalisation d'un système 600 comportant une mémoire 601 et des moyens de mise en oeuvre d'un procédé de gestion de l'usure de cette mémoire.

La mémoire 601 présente par exemple une organisation logique identique ou similaire à celle de la mémoire 100 de la figure 1. Sur la figure 6, seul un banc Bᵢ de la mémoire 601 a été représenté. La mémoire 601 comporte au moins deux ports permettant d'accéder simultanément à des portions distinctes de la mémoire. A titre d'exemple, chaque banc Bᵢ de la mémoire 601 comporte deux ports d'accès PT1 et PT2 permettant d'accéder simultanément à deux pages de segments S_{i,j} distincts du banc. Chaque banc Bᵢ de la mémoire 601 présente par exemple une architecture du type décrit en relation avec les figures 4 et 5, dans laquelle chaque portion de mémoire 401ⱼ (figures 4 et 5) correspond à un segment S_{i,j} du banc.

Le système 600 comprend un circuit de contrôle 603 (CTRL), comportant par exemple un circuit câblé spécifique ou un microcontrôleur. Le circuit 603 est adapté à recevoir des requêtes d'accès à la mémoire provenant de l'utilisateur (USER), et à traiter de façon prioritaire ces requêtes, en accédant aux bancs Bᵢ de la mémoire via les ports d'accès PT1 de ces bancs. Le circuit 603 est de plus adapté à mettre en oeuvre, parallèlement aux accès utilisateur, un procédé de gestion ou d'équilibrage de l'usure de la mémoire 601, comportant des déplacements de données à l'intérieur d'un même segment ou entre des segments distincts d'un même banc ou de bancs distincts, par exemple un procédé type décrit en relation avec les figures 2A à 2F. Pour effectuer les déplacements de données du procédé d'équilibrage d'usure, le circuit 603 accède à la mémoire via les ports d'accès PT2 des bancs Bᵢ. Lorsqu'un déplacement de données du procédé d'équilibrage d'usure est en cours de réalisation par le circuit de contrôle 603, à l'intérieur d'un segment ou entre des segments distincts de la mémoire, le circuit 603 peut accéder aux données à déplacer à chaque cycle où le ou les segments contenant ces données ne sont pas utilisés, soit parce qu'aucun accès à la mémoire n'est effectué par l'utilisateur, soit parce que l'utilisateur utilise d'autres segments de la mémoire. Pour que les déplacements de données mis en oeuvre par le procédé d'équilibrage d'usure soient, du point de vue de l'adressage, transparents pour l'utilisateur, le système 600 peut comporter un dispositif de conversion d'adresse (non représenté sur la figure 6) du type décrit en relation avec la figure 3. Le dispositif de conversion d'adresse peut être tenu à jour par le circuit 603 au fur et à mesure que les déplacements de données sont effectués.

Dans l'exemple de la figure 6, le système 600 comprend, deux tables t1 et t2 comportant chacune un nombre d'entrées ou valeurs de 2 bits égal au nombre de pages P_{i,j,k} que contient un segment S_{i,j}, soit p entrées de 2 bits dans cet exemple. De plus, le système 600 comprend deux registres REGA et REGB adaptés à mémoriser chacun le contenu d'une page P_{i,j,k} de la mémoire. Le circuit de contrôle 603 est adapté à lire et écrire dans les tables t1 et t2 et les registres REGA et REGB. A titre d'exemple, non limitatif, les tables t1 et t2 et les registre REGA et REGB peuvent être réalisés dans une mémoire de technologie différente de celle de la mémoire 601, par exemple dans une mémoire présentant des temps d'accès plus courts que la mémoire 601, par exemple une mémoire SRAM (de l'anglais "Static Random Access Memory" - mémoire statique à accès aléatoire).

Lorsqu'un déplacement de contenu de pages à l'intérieur d'un segment est effectuée par le circuit 603, le circuit 603 peut affecter la table t1 au segment S_{i,j} concerné, et tenir à jour la table t1. Pour chaque page du segment S_{i,j}, la table t1 indique l'état de la page parmi les possibilités suivantes :
le contenu de la page n'a pas été transféré ; ou
le contenu de la page est dans le registre REGA (en cours de transfert) ; ou
le contenu de la page est dans le registre REGB (en cours de transfert) ; ou
le contenu de la page a été transféré dans une autre page.

A titre d'exemple, pour réaliser une rotation circulaire interne d'un segment S_{i,j} du banc Bᵢ lors de la mise en oeuvre du procédé de la figure 2B, le circuit 603 peut par exemple, à chaque cycle où le segment S_{i,j} n'est pas utilisé par l'utilisateur, soit parce qu'aucun accès à la mémoire n'est effectué par l'utilisateur dans le banc Bᵢ, soit parce que l'utilisateur utilise un autre segment du banc Bᵢ, mettre en oeuvre l'une des étapes du procédé suivant :
lire le contenu de la première page P_{i,j,1} du segment S_{i,j}, écrire ce contenu dans le registre REGA, et mettre à jour la table t1 pour cette page ;
lire le contenu de la deuxième page P_{i,j,2} du segment S_{i,j}, écrire ce contenu dans le registre REGB, et mettre à jour la table t1 pour cette page ;
écrire le contenu du registre REGA dans la deuxième page P_{i,j,2} du segment et mettre à jour la table t1 pour la page P_{i,j,1} ;
lire le contenu de la troisième page P_{i,j,3} du segment S_{i,j}, écrire ce contenu dans le registre REGA, et mettre à jour la table t1 pour cette page ;
écrire le contenu du registre REGB dans la troisième page P_{i,j,3} du segment et mettre à jour la table t1 pour la page P_{i,j,2} ;
et ainsi de suite jusqu'au transfert du contenu de la dernière page P_{i,j,p} du segment dans la première page P_{i,j,1}.

Plus généralement, des procédés du même type peuvent être mis en oeuvre par le circuit 603 pour déplacer des données soit à l'intérieur d'un même segment S_{i,j} soit entre des segments distincts de la mémoire, quels que soient les déplacements envisagés (rotation circulaire des mots de la page - figure 2A, permutation de segments à l'intérieur d'un banc - figure 2C, rotation circulaire de segments à l'intérieur d'un banc - figure 2D, permutation de bancs - figure 2E, rotation circulaire des bancs de la mémoire - figure 2F, ou autres) . Lorsqu'un déplacement de contenus de pages entre des premier et deuxième segments distincts est effectué, le circuit 603 peut affecter la table t1 au premier segment et affecter la table t2 au deuxième segment, et tenir à jour les tables t1 et t2. Les tables t1 et t2 indiquent l'état (transférée, pas transférée, ou en cours de transfert) de chacune des pages de chacun des deux segments concernés. Les déplacements comportant plusieurs permutations de contenus de segments à l'intérieur d'un même banc peuvent être effectués séquentiellement.

Si un accès utilisateur survient dans un segment S_{i,j} alors qu'un déplacement de données en cours affecte ce segment, le circuit 603 peut consulter la table t1 ou t2 affectée au segment pour savoir :
si le contenu de la page visée a déjà été transféré, auquel cas la donnée est lue ou écrite à sa nouvelle adresse dans la mémoire ;
si le contenu de la page visée est dans le registre REGA ou dans le registre REGB, auquel cas la donnée est lue ou écrite dans le registre REGA ou REGB ; ou
si le contenu de la page visée n'a pas été transféré, auquel cas la donnée est lue ou écrite à son adresse d'origine dans le segment S_{i,j}.

Le système 600 de la figure 6 permet de mettre en oeuvre un procédé de gestion ou d'équilibrage d'usure impliquant des déplacements de contenus à l'intérieur de la mémoire, ces déplacements de contenus étant transparents pour l'utilisateur de la mémoire tant du point de vue de l'adressage des données par l'utilisateur que du point de vue des temps d'accès aux données par l'utilisateur.

Dans un exemple de réalisation non limitatif, le circuit 603 peut être cadencé par une horloge de fréquence supérieure à celle de la mémoire 601, et des accès utilisateur à la mémoire peuvent être effectués à n'importe quel cycle d'horloge du circuit 603. Dans ce cas, il peut être souhaitable de ne pas effectuer d'opération de lecture ou d'écriture dans un segment S_{i,j} de la mémoire dans le cadre du procédé d'équilibrage d'usure, lorsque le banc Bᵢ contenant ce segment n'est pas lu ou écrit par l'utilisateur. En effet, une opération de lecture ou d'écriture entamée dans le segment S_{i,j} dans le cadre du procédé d'équilibrage d'usure, pourrait empêcher de répondre immédiatement à une requête de l'utilisateur en lecture ou en écriture dans ce même segment S_{i,j}. Ainsi, dans une variante de réalisation, le circuit 603 peut être configuré pour n'accéder à un segment S_{i,j} de la mémoire dans le cadre du procédé d'équilibrage d'usure que simultanément à un accès utilisateur à un autre segment S_{i,j'} du même banc.

En outre, dans le cas où les accès en écriture à la mémoire sont plus longs que les accès en lecture, il peut être souhaitable de pas effectuer d'opération d'écriture dans un segment S_{i,j} de la mémoire dans le cadre du procédé d'équilibrage d'usure, lorsqu'un autre segment S_{i,j'} du même banc Bᵢ est simultanément lu par l'utilisateur. En effet, une opération d'écriture entamée dans le segment S_{i,j} dans le cadre du procédé d'équilibrage d'usure, pourrait empêcher de répondre immédiatement à une requête utilisateur visant le segment S_{i,j} après la fin de la lecture utilisateur dans le segment S_{i,j'}. Ainsi, dans une variante de réalisation, le circuit 603 peut être configuré pour n'accéder en écriture à un segment S_{i,j} de la mémoire dans le cadre du procédé d'équilibrage d'usure que simultanément à un accès utilisateur en écriture à un autre segment S_{i,j'} du même banc. Dans une autre variante, si les accès en lecture à la mémoire sont plus longs que les accès en écriture, le circuit 603 peut être configuré pour n'accéder en lecture à un segment S_{i,j} de la mémoire dans le cadre du procédé d'équilibrage d'usure que simultanément à un accès utilisateur en lecture à un autre segment S_{i,j'} du même banc.

On notera que les mécanismes susmentionnés ne permettent d'effectuer les déplacements de données du procédé d'équilibrage d'usure que si, pendant au moins un certain pourcentage du temps de fonctionnement du système, le ou les segments contenant les données à déplacer ne sont pas lus ou écrits par l'utilisateur. En revanche, si une suite ininterrompue d'accès à différentes adresses d'un segment S_{i,j} contenant des données à déplacer est réalisée par l'utilisateur, le procédé d'équilibrage d'usure sera mis en attente tout en laissant ce segment s'user prématurément. Une telle séquence ininterrompue d'accès à un segment pendant une longue durée peut être due à l'utilisation intensive par une application utilisateur d'une petite partie de la mémoire, ou peut être le résultat d'un usage malveillant visant à user volontairement la mémoire pour la détruire.

Dans une variante de réalisation, pour éviter un tel usage prématuré d'un segment S_{i,j} de la mémoire, on peut prévoir de brouiller les adresses utilisateur à l'aide d'une clé de cryptage, par exemple stockée dans la mémoire à sa fabrication. A titre d'exemple, les adresses utilisateur peuvent être combinées avec la clé de cryptage à l'aide d'une porte OU Exclusif, avant d'être utilisées par le circuit de contrôle 603 pour accéder à la mémoire. Une application n'utilisant qu'une partie de la mémoire voit alors ses accès répartis dans différents segments de la mémoire. En outre, il devient plus difficile pour un utilisateur malveillant de trouver une séquence d'adresses permettant d'accéder sans interruption à différentes adresses d'un même segment S_{i,j} de la mémoire. De préférence, dans l'architecture de la figure 6, les adresses de banc ne sont pas brouillées. En effet, les bancs Bᵢ de la mémoire 601 pouvant être adressés en parallèle, il est préférable que l'utilisateur puisse savoir si les données auxquelles il souhaite accéder sont contenues dans un même banc ou dans des bancs différents.

L'utilisation d'une clé de cryptage pour brouiller les adresses à l'intérieur des bancs Bᵢ ne permet toutefois pas de protéger la mémoire contre une utilisation malveillante écrivant ou lisant continument la même adresse de la mémoire sans interruption, dans le but d'user volontairement la mémoire pour la détruire.

Pour prévenir ce risque, le circuit 603 ou un circuit utilisateur amont (non représenté) peut être configuré pour insérer un accès à un autre segment ou un cycle vide entre deux accès utilisateurs consécutifs à une même adresse de la mémoire.

Alternativement, le système 600 peut comprendre un cache, c'est-à-dire une mémoire tampon faisant interface entre la mémoire 601 et l'utilisateur, ce cache étant adapté à stocker le contenu d'une ou plusieurs pages et de leurs adresses. Lors d'un accès utilisateur à la mémoire, le circuit de contrôle 603 regarde si l'adresse visée par l'utilisateur est déjà présente dans le cache. Si oui, le circuit de contrôle 603 accède à la donnée dans le cache (en lecture ou en écriture), sans passer par la mémoire. Si non, le circuit de contrôle 603 accède à la donnée dans la mémoire (en lecture ou en écriture), et écrit dans le cache la donnée lue ou écrite dans la mémoire ainsi que son adresse. Ainsi, des accès successifs à un nombre restreint de données, non seulement n'usent pas la mémoire puisqu'ils ont lieu dans le cache, mais laissent en outre des cycles libres pour la mise en oeuvre du procédé d'équilibrage d'usure. Plus la taille du cache est importante, plus l'efficacité de la protection est élevée. Si le cache a une taille permettant de stocker l'intégralité du contenu d'un segment, le mécanisme susmentionné de brouillage des adresses au moyen d'une clé de cryptage peut être omis.

La figure 7 représente de façon schématique et partielle une variante de réalisation du système 600 de la figure 6. Le système 700 de la figure 7 comprend des éléments communs avec le système de la figure 6. Dans la suite, seules les différences entre les systèmes 600 et 700 seront soulignées.

Dans cet exemple, le système 700 de la figure 7 comprend la même mémoire 601 que le système 600 de la figure 6, et comprend des moyens de mise en oeuvre d'un procédé de gestion de l'usure de cette mémoire. Le système 700 de la figure 7 diffère du système 600 de la figure 6 principalement par les moyens utilisés pour mettre en oeuvre des déplacements de données dans la mémoire 601 dans le cadre du procédé de gestion d'usure.

Le système 700 comprend un circuit de contrôle 703 (CTRL), comportant par exemple un circuit câblé spécifique ou un microcontrôleur. Le circuit 703 est adapté à recevoir des requêtes d'accès à la mémoire provenant de l'utilisateur (USER), et à traiter de façon prioritaire ces requêtes, en accédant à chaque banc Bᵢ de la mémoire via le port d'accès PT1 de ce banc. Le circuit 703 est de plus adapté à mettre en oeuvre, parallèlement aux accès utilisateur, un procédé de gestion ou d'équilibrage de l'usure de la mémoire 601, comportant des déplacements de données à l'intérieur d'un même segment ou entre des segments distincts de la mémoire 601. Pour effectuer ces déplacements de données du procédé d'équilibrage d'usure, le circuit 703, comme le circuit 603 de la figure 6, accède à la mémoire 601 via les ports d'accès PT2 des bancs Bᵢ, uniquement lorsque les segments contenant les données à déplacer ne sont pas utilisés par l'utilisateur.

Le système 700 ne comprend pas les tables t1 et t2 ni les registres REGA et REGB du système 600 de la figure 6. Le système 700 comprend en revanche deux mémoires tampons MEM1 et MEM2 de taille permettant de mémoriser chacune le contenu d'un segment S_{i,j} entier de la mémoire 601, c'est-à-dire le contenu de p pages P_{i,j,k} dans cet exemple. Les mémoires MEM1 et MEM2 peuvent être des mémoires présentant des temps d'accès en lecture et en écriture plus courts que la mémoire 601. A titre d'exemple, les mémoires MEM1 et MEM2 sont des mémoires SRAM. Le système 700 comprend de plus deux tables t1' et t2', associées respectivement aux mémoires MEM1 et MEM2, comportant chacune un nombre d'entrées ou valeurs de 1 bit égal au nombre de pages P_{i,j,k} que contient un segment S_{i,j}, soit p entrées de 1 bits dans cet exemple.

A chaque fois qu'un déplacement de données interne à un segment S_{i,j} de la mémoire est effectué dans le cadre du procédé de gestion d'usure, toutes les entrées de la table t1' sont d'abord mise à un même premier état, par exemple à la valeur binaire '0'. Pour chaque page du segment S_{i,j}, la table t1' indique si le contenu de la page a (valeur binaire '1' dans cet exemple) ou n'a pas (valeur binaire '0' dans cet exemple) été transféré dans la mémoire tampon MEM1. Le contenu du segment S_{i,j} est ensuite entièrement copié, page par page, dans la mémoire MEM1 par le circuit de contrôle 703 lors d'une première phase de copie. Au fur et à mesure de la copie du contenu du segment S_{i,j} dans la mémoire MEM1, les entrées de la table t1' sont mises à jour par le circuit 703. Avant de copier le contenu d'une page dans la mémoire MEM1, le circuit 703 vérifie, via la table t1', que cette page n'a pas déjà été copiée dans la mémoire MEM1. Dans cet exemple, le circuit 703 n'effectue la copie d'une page que si l'entrée correspondante dans la table t1' est à la valeur '0'.

Lorsque tout le contenu du segment S_{i,j} a été copié dans la mémoire MEM1, le contenu de la mémoire MEM1 est recopié dans le segment S_{i,j}, en plaçant le contenu de chaque page de la mémoire MEM1 à sa nouvelle destination dans le segment S_{i,j}, lors d'une deuxième phase de copie. A chaque fois qu'une page de la mémoire MEM1 est recopiée dans le segment S_{i,j}, la table t1' est mise à jour pour cette page.

Si un accès utilisateur intervient dans un segment S_{i,j} pendant un déplacement de données à l'intérieur de ce segment, le circuit 703 vérifie si la première phase de copie du contenu du segment S_{i,j} dans la mémoire MEM1 est terminée ou non. Si la première phase de copie n'est pas terminée, le circuit 703 regarde dans la table t1' si le contenu de la page P_{i,j,k} visée a déjà été transféré dans la mémoire MEM1 ou non. Si non, si l'accès utilisateur est un accès en écriture, la donnée utilisateur est écrite dans la mémoire MEM1 directement, et si l'accès utilisateur est un accès en lecture, la donnée est lue dans le segment S_{i,j}, transmise à l'utilisateur, et écrite dans la mémoire MEM1. La table t1' est mise à jour (mise à l'état '1' dans cet exemple) pour la page P_{i,j,k}. Si le contenu de la page P_{i,j,k} visée par l'utilisateur a déjà été transféré dans la mémoire MEM1, l'accès utilisateur (en lecture ou en écriture) se fait directement dans la mémoire MEM1. Si la première phase de copie est terminée et si le circuit 703 effectue la deuxième phase de recopie du contenu de la mémoire MEM1 dans le segment S_{i,j}, les accès utilisateurs en lecture et en écriture peuvent être effectués dans la mémoire MEM1. Si l'accès utilisateur est un accès en écriture, la table t1' est mise à jour pour la page écrite, pour indiquer que cette page n'a pas encore été recopiée dans le segment S_{i,j} (mise à l'état '1' dans cet exemple). A la fin de la phase de recopie du contenu de la mémoire MEM1 dans le segment S_{i,j}, une ou plusieurs phases supplémentaires de recopie peuvent être effectuées pour transférer dans le segment S_{i,j} le contenu des pages qui auraient été écrites par l'utilisateur dans la mémoire MEM1 après avoir déjà été recopiées une fois dans le segment S_{i,j}. La phase de déplacement de données à l'intérieur du segment se termine lorsque toutes les entrées de la table t1' sont à l'état '0'.

Une suite ininterrompue d'accès utilisateur en lecture aux données du segment S_{i,j} n'empêche pas le circuit 703 d'effectuer le déplacement de données du procédé d'équilibrage d'usure, puisque les pages non-encore transférées dans la mémoire MEM1 le sont à l'occasion des accès utilisateur, et que les pages déjà transférées sont lues directement dans la mémoire MEM1, en parallèle avec un autre transfert de page du segment S_{i,j} vers la mémoire MEM1.

Une suite ininterrompue d'écritures utilisateur dans une même page P_{i,j,k} du segment S_{i,j} pourrait empêcher le déplacement de données du procédé d'équilibrage d'usure de se poursuivre, mais n'userait pas le segment S_{i,j}, puisque les accès utilisateur en écriture se font tous dans la mémoire MEM1.

Une suite ininterrompue d'écritures utilisateur à des adresses différentes du segment S_{i,j} pendant la phase de recopie du contenu de la mémoire MEM1 dans le segment S_{i,j}, pourrait empêcher le déplacement de données du procédé d'équilibrage d'usure de se poursuivre tout en laissant le segment S_{i,j} s'user prématurément. Toutefois, une telle séquence ininterrompue d'accès en écriture (sans accès en lecture) pendant une longue durée, ne peut être le résultat que d'un usage malveillant visant à détruire la mémoire. Ceci peut être évité en utilisant un mécanisme de brouillage des adresses du type décrit en relation avec la figure 6, utilisant une clé de cryptage, ou un mécanisme de cache.

Lorsqu'un déplacement de données entre deux segments S_{i,j} et S_{i'},_{j'} distincts de la mémoire est effectué dans le cadre du procédé de gestion d'usure, les deux mémoires tampons MEM1 et MEM2 sont utilisées, ainsi que les deux tables t1' et t2'. La permutation des contenus des deux segments comprend une première phase de copie du contenu du segment destination dans la mémoire MEM1, une deuxième phase de copie du contenu du segment source dans la mémoire MEM2, une troisième phase de copie du contenu de la mémoire MEM1 dans le segment source, et une quatrième phase de copie du contenu de la mémoire MEM2 dans le segment destination. Les différentes phases de copie ainsi que les accès utilisateurs aux contenus des segments source et destination peuvent être gérés par le circuit de contrôle 703 à l'aide des tables t1' et t2', de façon similaire à ce qui a été décrit ci-dessus pour le cas d'un déplacement interne à un segment.

Dans les exemples de réalisation des figures 6 et 7, si les mémoires utilisées pour réaliser les tables t1 et t2 (figure 6) les registres REGA et REGB (figure 6), les tampons MEM1 et MEM2 (figure 7), les tables t1' et t2' (figure 7), ainsi que d'autres éléments de stockage de données utiles à la mise en oeuvre du procédé d'équilibrage d'usure (compteurs d'accès mémoire, tables de traduction d'adresses utilisateur en adresses physiques, registres de suivi de déplacements, etc.) sont des mémoires volatiles, par exemple réalisées en technologie SRAM, on peut prévoir, à la mise hors tension du système, de transférer les données contenues dans ces divers éléments de stockage dans une mémoire non volatile.

Des modes de réalisation particuliers ont été décrits. Diverses variantes et modifications apparaîtront à l'homme de l'art.

En particulier, les modes de réalisation décrits ne se limitent pas aux exemples susmentionnés d'organisation logique des cellules élémentaires dans une mémoire ni aux exemples susmentionnés de déplacements de données dans la mémoire pour équilibrer son usure.

Plus généralement, quelle que soit l'organisation logique interne de la mémoire, et quels que soient les déplacements de données envisagés pour équilibrer l'usure de la mémoire, l'homme du métier saura, à partir de l'enseignement décrit ci-dessus, réaliser un système comportant une mémoire comportant plusieurs portions de plusieurs pages chacune, cette mémoire comportant des premier et deuxième ports permettant d'accéder simultanément à deux pages de portions distinctes de la mémoire, ce système comportant un circuit de contrôle adapté à mettre en oeuvre un procédé d'équilibrage d'usure en utilisant le deuxième port pour réaliser les déplacements de données du procédé d'équilibrage d'usure, tout en permettant à l'utilisateur d'accéder de façon prioritaire au contenu de la mémoire via le premier port.

De plus, les modes de réalisation décrits ne se limitent pas aux exemples particuliers décrits en relation avec les figures 6 et 7 de moyens permettant d'effectuer les déplacement de données du procédé d'équilibrage d'usure et de gérer en parallèle les accès utilisateur. On notera en particulier que lorsque le procédé d'équilibrage d'usure comprend des rotations circulaires de données à l'intérieur d'une page, par exemple du type décrit en relation avec la figure 2A, le système peut comprendre un ou plusieurs circuits spécifiques adaptés à effectuer un décalage circulaire du contenu d'une page pendant un cycle de lecture ou d'écriture dans la mémoire principale.

En outre, les modes de réalisation décrits ne se limitent pas aux exemples de déplacements de données décrits en relation avec les figures 2A à 2F. Plus généralement, les modes de réalisation décrits sont compatibles avec tous types de déplacements de données effectués dans une mémoire à des fins d'équilibrage de l'usure de la mémoire. A titre d'exemple, après un certain nombre d'accès à un segment S_{i,j} de la mémoire, on peut prévoir de décaler circulairement d'un même incrément (par exemple d'un bit, d'un octet ou d'un mot) le contenu de chacune des pages du segment. A titre de variante, après un certain nombre d'accès à un segment S_{i,j} de la mémoire, on peut prévoir de décaler circulairement d'un incrément (par exemple d'un bit, d'un octet ou d'un mot) le contenu du segment entier. Dans cette dernière variante, les données initialement contenues dans une page de la mémoire peuvent se retrouver réparties dans deux pages consécutives de la mémoire. Un accès utilisateur en lecture ou en écriture peut alors nécessiter d'accéder physiquement à deux pages distinctes de la mémoire, ce qui peut augmenter les temps d'accès aux données du point de vue de l'utilisateur. Pour éviter d'augmenter les temps d'accès aux données, on peut prévoir de diviser la mémoire en deux mémoires à deux ports du type décrit en relation avec les figures 4, 5, 6 et 7, chaque portion de la première mémoire pouvant contenir les pages de rang impair d'un segment S_{i,j}, et chaque portion de la deuxième mémoire pouvant contenir les pages de rang pair d'un segment S_{i,j}. L'utilisateur, comme le système d'équilibrage d'usure, peuvent alors accéder en même temps à deux pages consécutives d'un même segment S_{i,j}, ce qui permet de répondre aux requêtes utilisateur ou aux requêtes du procédé d'équilibrage d'usure en un seul cycle mémoire.

Par ailleurs, les modes de réalisation décrits ne se limitent pas aux exemples susmentionnés de technologies de mémoires résistives. Plus généralement, les modes de réalisation décrits sont compatibles avec toutes les technologies de mémoires résistives ou non résistives sujettes à l'usure.

Par ailleurs, on a décrit ci-dessus des modes de réalisation dans lesquels un procédé d'équilibrage d'usure comportant des déplacements de données à l'intérieur de la mémoire est mis en oeuvre via un port de la mémoire distinct du port utilisé pour les accès utilisateur. Les modes de réalisation décrits visent cependant aussi des procédés de gestion d'usure ne comportant pas de déplacements de données à l'intérieur de la mémoire, c'est-à-dire ne conduisant pas à modifier l'emplacement physique des données dans la mémoire. A titre d'exemple, les modes de réalisation décrits sont compatibles avec un procédé de gestion d'usure comportant des opérations de rafraîchissement de données contenues dans des pages de la mémoire. Une telle opération de rafraîchissement comprend par exemple une étape de lecture des données contenues dans une page de la mémoire, suivie d'une étape de réécriture des données lues à la même adresse dans la mémoire. Dans ce cas, on prévoit, similairement à ce qui a été décrit ci-dessus, que les étapes de lecture et d'écriture des cycles de rafraichissement soient mises en oeuvre via le port d'accès dédié à la gestion d'usure, de façon à être transparentes pour l'utilisateur. Plus généralement, les modes de réalisation décrits sont compatibles avec tous types de procédés de gestion d'usure comportant des accès en lecture et/ou en écriture aux données stockées dans la mémoire.

De plus, on a décrit ci-dessus des exemples de réalisation dans lesquels, pour estimer l'usure d'une portion de mémoire et décider en conséquence de mettre en oeuvre ou non un procédé de gestion d'usure ciblant cette portion, on compte les accès en lecture et/ou en écriture à la portion de mémoire. Les modes de réalisation décrits ne se limitent toutefois pas à ce cas particulier. Plus généralement, toute autre méthode permettant de mesurer ou estimer l'usure d'une portion de mémoire résistive peut être utilisée pour décider la planification des procédés de gestion d'usure.

Ces méthodes de mesure d'usure peuvent par exemple être mises en oeuvre par les circuits de contrôle 603 ou 703 des figures 6 et 7, ou par tout autre circuit adapté. Les différentes étapes de lecture et/ou d'écriture des procédés de mesure d'usure peuvent être mises en oeuvre via le port d'accès dédié à la gestion d'usure, de façon à être transparentes pour l'utilisateur.

De plus, pour prolonger davantage sa durée de vie, la mémoire peut comporter une réserve de cellules redondantes prévue à la conception du circuit, c'est-à-dire des cellules inutilisées au début du cycle de vie de la mémoire et destinées à remplacer des cellules ayant atteint un seuil critique d'usure après un certain temps d'utilisation. Les procédés de gestion d'usure peuvent, lorsqu'un mot ou une page atteint un seuil d'usure critique, remplacer le mot ou la page usée par un mot ou une page "neuve" de la réserve de cellules redondantes.

A titre d'exemple, l'usure d'une page d'une mémoire résistive peut être mesurée par un procédé du type décrit dans la demande de brevet US2013/0235649. Un tel procédé de mesure d'usure consiste substantiellement en : lire la page dont on souhaite mesurer l'usure et stocker la donnée lue dans un élément de stockage intermédiaire ; écrire à l'état fortement résistif (valeur binaire '0') tous les bits de la page ; appliquer une tension de polarisation et mesurer la somme des courants circulant dans les cellules élémentaires de la page ; puis réécrire dans la page la donnée mémorisée dans l'élément de stockage intermédiaire. La somme ou valeur moyenne des courants circulant dans les cellules élémentaires de la page constitue alors un indicateur d'usure de la page. En effet, plus le courant est élevé, plus la résistance des cellules à l'état fortement résistif est faible, et plus la page est considérée usée. Cette mesure peut être comparée à celle d'autres pages pour la planification d'un procédé de gestion d'usure du type décrit ci-dessus.

A titre de variante, le procédé de mesure d'usure peut comporter non seulement une première mesure de courant après que les cellules de la page aient été programmées à l'état fortement résistif (valeur binaire '0'), mais aussi une deuxième mesure de courant après que les cellules de la page aient été programmées à l'état faiblement résistif (valeur binaire '1'). Dans ce cas, la différence entre les deux valeurs de courant lues peut constituer un indicateur d'usure de la page. Un avantage est alors que le critère d'appréciation de l'usure est représentatif de la différence de résistivité entre l'état fortement résistif et l'état faiblement résistif des cellules de la page, qui est la grandeur permettant effectivement aux cellules de mémoriser des données.

A titre de variante, on peut prévoir un procédé de mesure d'usure basé sur les principes suivants :
le contenu courant de la page dont on souhaite déterminer l'usure sert de base à la mesure d'usure, de façon à éviter l'étape d'écriture de tous les bits de la page à une même valeur (contribuant à l'usure du mot) ; et
l'usure des différents bits de la page est appréciée individuellement, la page étant considérée usée dès lors que l'un de ses bits a atteint un seuil d'usure critique (ce qui permet de détecter des cas d'usure dans lesquels un seul bit de la page, ou un faible nombre de bits de la page, sont usés, cas qui pourraient ne pas être détectés par les méthodes précédentes de mesure du courant moyen circulant dans la page).

Un tel procédé peut par exemple comporter les étapes successives suivantes :
lire une première fois le contenu de la page dont on souhaite mesurer l'usure avec un seuil de courant standard de discrimination entre les valeurs binaires '0' et '1' (c'est-à-dire un seuil égal au seuil de discrimination utilisé, en fonctionnement normal, lors des accès utilisateur en lecture), et enregistrer la valeur lue dans un élément de stockage intermédiaire ;
lire une deuxième fois le contenu de la page avec un seuil de courant de discrimination entre les valeurs binaires '0' et '1' abaissé par rapport au seuil standard, et comparer la valeur lue avec la valeur mémorisée dans l'élément de stockage intermédiaire en effectuant un OU EXCLUSIF bit à bit entre les deux valeurs ; et
si au moins l'un des bits de sortie du OU EXCLUSIF est à la valeur binaire '1', en déduire que le bit correspondant de la page est usé.

On notera que le niveau d'usure mesuré dépend alors du décalage entre le seuil standard de discrimination entre les valeurs binaires '0' et '1', et le seuil de discrimination abaissé utilisé lors de la deuxième lecture. Le cas échéant, un nombre de lectures supérieur à deux peut être réalisé en utilisant des seuils de discrimination distincts lors des différentes lectures.

A titre d'exemple, pour analyser l'usure d'un segment de la mémoire, on peut prévoir un procédé comportant une étape d'initialisation, par exemple à la valeur 0, d'un compteur de pages usées du segment, puis, pour chaque page du segment, les étapes suivantes :
a) lire une première fois le contenu de la page avec un premier seuil de discrimination entre les valeurs binaires '0' et '1' égal au seuil standard de discrimination, et mémoriser la valeur lue dans un élément de stockage intermédiaire ;
b) lire une deuxième fois le contenu de la page avec un deuxième seuil de discrimination entre les valeurs binaires '0' et '1' abaissé par rapport au premier seuil, puis comparer la valeur lue avec la valeur mémorisée dans l'élément de stockage intermédiaire en effectuant un OU EXCLUSIF entre les deux valeurs ;
c) si au moins l'un des bits du résultat du OU EXCLUSIF est à la valeur binaire '1', en déduire que la page présente un niveau d'usure avancé ;
d) lire une troisième fois le contenu de la page avec un troisième seuil de discrimination entre les valeurs binaires '0' et '1' rehaussé par rapport au premier seuil, puis comparer la valeur lue avec la valeur mémorisée dans l'élément de stockage intermédiaire en effectuant un OU EXCLUSIF entre les deux valeurs ;
e) si au moins l'un des bits du résultat du OU EXCLUSIF est à la valeur binaire '1', en déduire que la page présente un niveau d'usure avancé ;
f) si la page est jugée comme présentant un niveau d'usure avancé suite à la deuxième ou à la troisième lecture, et si des pages redondantes sont disponibles dans la mémoire, remplacer la page par une page redondante, c'est-à-dire réaffecter à une page redondante l'adresse utilisateur correspondant à la page usée ;
g) si la page est jugée comme présentant un niveau d'usure avancé suite à la deuxième ou à la troisième lecture, et si aucune page redondante n'est disponible, déclencher la machine de permutation de segment afin de permuter le contenu du segment avec celui d'un segment moins usé, et cesser l'analyse d'usure du segment ;
h) si la page n'est pas jugée comme présentant un niveau d'usure avancé, lire une quatrième fois le contenu de la page avec un quatrième seuil de discrimination entre les valeurs binaires '0' et '1' abaissé par rapport au deuxième seuil, puis comparer la valeur lue avec la valeur mémorisée dans l'élément de stockage intermédiaire en effectuant un OU EXCLUSIF entre les deux valeurs ;
i) si au moins l'un des bits du résultat du OU EXCLUSIF est à la valeur binaire '1', en déduire que la page présente un niveau d'usure intermédiaire inférieur au niveau d'usure avancé susmentionné ;
j) lire alors une cinquième fois le contenu de la page avec un cinquième seuil de discrimination entre les valeurs binaires '0' et '1' rehaussé par rapport au troisième seuil, puis comparer la valeur lue avec la valeur mémorisée dans l'élément de stockage intermédiaire en effectuant un OU EXCLUSIF entre les deux valeurs ;
k) si au moins l'un des bits du résultat du OU EXCLUSIF est à la valeur binaire '1', en déduire que la page présente un niveau d'usure intermédiaire inférieur au niveau d'usure avancé ; et
l) si la page est jugée comme présentant un niveau d'usure intermédiaire suite à la quatrième ou à la cinquième lecture, incrémenter le compteur de pages usées du segment.

Lorsque toutes les pages du segment ont été ainsi testées, la valeur du compteur de pages usées du segment est comparée à une valeur de nombre de pages usées préalablement déterminée et mémorisée pour ce segment. Si la nouvelle valeur est supérieure à l'ancienne valeur, la nouvelle valeur est mémorisée et vient remplacer l'ancienne valeur. Si la nouvelle valeur de nombre de pages usées est supérieure à un seuil, un mécanisme de permutation du contenu du segment avec le contenu d'un autre segment moins usé peut être déclenché ou programmé. Sinon, un mécanisme de permutation des contenus des pages à l'intérieur du segment peut être déclenché ou programmé.

Si une lecture utilisateur survient dans le segment en cours d'analyse, cette lecture peut être faite directement dans la mémoire, étant donné que le contenu du segment n'est pas affecté par le procédé d'analyse d'usure.

En revanche, si une écriture utilisateur survient dans une page en cours d'analyse, cette écriture est effectuée à la fois dans la mémoire et dans l'élément de stockage intermédiaire mémorisant le contenu de la page. Ainsi, les éléments de stockage intermédiaire utilisés pour la mise en oeuvre du procédé d'analyse d'usure de la mémoire peuvent notamment comporter un registre d'adresse mémorisant l'adresse de la page en cours d'analyse, de façon à pouvoir comparer cette adresse à l'adresse visée par l'utilisateur lors d'un accès utilisateur en écriture.

On notera que les étapes d), e), j) et k) sont facultatives. En d'autres termes, on peut se dispenser de lire les données avec des seuils de discrimination rehaussés par rapport au seuil standard. En effet, généralement, l'usure d'une page se traduit essentiellement par une diminution de la résistance de la cellule lorsque la cellule est programmée à l'état fortement résistif. Ainsi, la seule lecture avec un seuil de discrimination abaissé par rapport au seuil standard peut être suffisante pour détecter des cellules usées.

Les différentes étapes de lecture et/ou d'écriture du procédé de mesure d'usure peuvent être mises en oeuvre via le port d'accès dédié à la gestion d'usure, de façon à être transparentes pour l'utilisateur.

Par ailleurs, dans l'exemple de la figure 6, on a décrit un système comportant des tables t1, t2 comportant chacune p mots de 2 bits, indiquant si une page d'un segment en cours de transfert a ou non été transférée. A titre de variante, si le transfert des pages est effectué dans l'ordre croissant ou décroissant des adresses du segment, les tables t1, t2 peuvent être omises et un compteur peut être incrémenté à chaque transfert de page. Lors d'un accès utilisateur, l'adresse visée par l'utilisateur peut être comparée à la valeur du compteur, pour savoir si la page correspondante a ou non été transférée.

De plus, les modes de réalisation décrits sont compatibles avec des procédés de gestion d'usure visant à "réparer" des cellules usées, ou à écrire de façon robuste des données dans des cellules usées. Un tel procédé peut par exemple consister à écrire et effacer alternativement une pluralité de fois des cellules défectueuses. A titre de variante ou à titre complémentaire, une cellule défectueuse peut être au moins partiellement régénérée en effectuant une réinitialisation de la cellule, c'est-à-dire en lui appliquant une tension de programmation de même polarité que la tension normalement utilisée pour écrire la cellule à l'état faiblement résistif, mais de valeur supérieure, et pendant une durée pouvant être supérieure à la durée normale d'écriture d'une cellule.

A titre d'exemple, lorsqu'un mot défectueux est identifié (par exemple par un procédé de mesure d'usure du type susmentionné) ou lorsqu'une écriture incorrecte d'un mot est détectée, un procédé comportant les étapes suivantes peut être mis en oeuvre.
a) Mémoriser le contenu du mot et, le cas échéant, son adresse, dans un élément de stockage intermédiaire.
b) Ecrire (c'est-à-dire programmer à l'état faiblement résistif) puis effacer (c'est-à-dire programmer à l'état fortement résistif) les bits défectueux (lors de cette étape, on peut prévoir de ne traiter que les bits défectueux, pour ne pas user inutilement les autres bits du mot).
c) Mesurer l'usure du mot, par exemple via un procédé de mesure d'usure du type susmentionné, ou vérifier si l'état des cellules identifiées comme défectueuses est redevenu correct.
d) Si les cellules identifiées sont toujours défectueuses, réitérer les étapes b), c) et d). Sinon, terminer le procédé de réparation.
e) Lorsque le nombre d'itérations des étapes b), c) et d) atteint un seuil et que des cellules sont toujours défectueuses, copier l'intégralité du segment contenant le mot dans un segment redondant, et faire correspondre l'adresse utilisateur pour ce segment à l'adresse physique du nouveau segment.
f) Réinitialiser les bits défectueux du segment défectueux en leur appliquant une tension de programmation de même polarité que la tension normalement utilisée pour écrire la cellule à l'état faiblement résistif, mais de valeur supérieure, pendant une durée pouvant être supérieure à la durée normale d'écriture d'une cellule à l'état faiblement résistif.
g) Lorsque tous les bits défectueux du segment ont été réinitialisés, rendre le segment disponible dans la liste des segments redondants, et terminer le procédé de réparation.

On notera que, dans le cas où les cellules défectueuses sont à l'état faiblement résistif, les opérations d'écriture et d'effacement de l'étape b) peuvent être interverties.

Un tel procédé de réparation peut par exemple être mis en oeuvre par le circuit de contrôle 603 de la figure 6 ou 703 de la figure 7, ou par tout autre circuit adapté. Les différentes étapes de lecture et/ou d'écriture du procédé de réparation d'usure peuvent être mises en oeuvre via le port d'accès dédié à la gestion d'usure, de façon à être transparentes pour l'utilisateur.

Si un accès utilisateur visant un mot en cours de réparation survient, cet accès peut être effectué dans l'élément de stockage intermédiaire mémorisant le contenu du mot, ou, si le mot défectueux a été permuté avec un mot d'un segment redondant, dans le segment redondant devenu le nouveau segment physique pour la donnée visée.

## Revendications

1. Système (600 ; 700) comportant :
une mémoire résistive non volatile (400 ; 500 ; 601) comportant plusieurs portions (401ⱼ ; S_{i,j}) de plusieurs pages (P_{i,j,k}) chacune, cette mémoire comportant des premier (PT1) et deuxième (PT2) ports permettant d'accéder simultanément à deux pages de la mémoire à condition que ces pages appartiennent à des portions distinctes de la mémoire résistive non volatile, chacune desdites portions (401ⱼ ; S_{i,j}) comportant un unique port d'accès (A, dᵢₙ, dₒᵤₜ) aux pages de la portion, ce port pouvant être connecté à l'un ou l'autre des premier (PT1) et deuxième (PT2) ports de la mémoire résistive non volatile par des circuits de multiplexage (405ⱼ, 407ⱼ, MUX1, MUX2 ; S1ⱼ, S2ⱼ) ; et
un circuit de contrôle (603 ; 703) adapté à mettre en oeuvre, via le deuxième port (PT2), un procédé de gestion de l'usure de la mémoire résistive non volatile (400 ; 500 ; 601) comportant des accès en lecture et/ou en écriture aux données stockées dans la mémoire résistive non volatile, en autorisant simultanément des accès utilisateur au contenu de la mémoire résistive non volatile via le premier port (PT1), le circuit de contrôle (603 ; 703) étant adapté à n'effectuer un accès à une portion (401ⱼ ; S_{i,j}) de la mémoire résistive non volatile pour le procédé de gestion d'usure que lorsqu'aucun accès utilisateur n'est effectué sur cette portion de la mémoire résistive non volatile,
**caractérisé en ce que** le circuit de contrôle (603 ; 703) est adapté à être cadencé par une horloge de fréquence supérieure à celle de la mémoire résistive non volatile et **en ce que** des accès utilisateur à la mémoire résistive non volatile peuvent être effectués à n'importe quel cycle d'horloge du circuit de contrôle, et à n'effectuer un accès à une portion (401ⱼ ; S_{i,j}) de la mémoire résistive non volatile pour le procédé de gestion d'usure que lorsqu'un accès utilisateur est effectué simultanément sur une autre portion de la mémoire résistive non volatile.

2. Système (600 ; 700) selon la revendication 1, dans lequel ledit procédé de gestion d'usure est un procédé d'équilibrage d'usure comportant des déplacements de données conduisant à modifier l'adresse physique des données à l'intérieur de la mémoire résistive non volatile.

3. Système (600 ; 700) selon la revendication 1 ou 2, dans lequel le circuit de contrôle (603 ; 703) est adapté à traiter de façon prioritaire les accès utilisateur au contenu de la mémoire résistive non volatile par rapport aux accès du procédé de gestion d'usure.

4. Système (600 ; 700) selon l'une quelconque des revendications 1 à 3, dans lequel le circuit de contrôle (603 ; 703) est adapté à n'effectuer un accès en écriture à une portion (401ⱼ ; S_{i,j}) de la mémoire résistive non volatile pour le procédé de gestion d'usure que lorsqu'un accès utilisateur en écriture est effectué sur une autre portion de la mémoire résistive non volatile.

5. Système (600 ; 700) selon l'une quelconque des revendications 1 à 4, dans lequel le circuit de contrôle (603 ; 703) est adapté à n'effectuer un accès en lecture à une portion (401ⱼ ; S_{i,j}) de la mémoire résistive non volatile pour le procédé de gestion d'usure que lorsqu'un accès utilisateur en lecture est effectué sur une autre portion de la mémoire résistive non volatile.

6. Système (600) selon l'une quelconque des revendications 1 à 5, comportant en outre des premier (REGA) et second (REGB) registres adaptés à mémoriser chacun le contenu d'une page (M_{i,j,k,l}) de la mémoire résistive non volatile.

7. Système (600) selon la revendication 6, comportant en outre des première (t1) et deuxième (t2) tables adaptées à mémoriser chacune autant d'entrées de 2 bits qu'une portion (401ⱼ ; S_{i,j}) de la mémoire résistive non volatile comporte de pages (P_{i,j,k}).

8. Système (600) selon la revendication 6 ou 7, dans lequel, lorsque des données sont déplacées dans la mémoire résistive non volatile par le circuit de contrôle (603) dans le cadre du procédé de gestion d'usure, ces données transitent par les premier (REGA) et/ou second (REGB) registres, et, lorsqu'un accès utilisateur visant des données contenues dans les premier (REGA) et/ou second (REGB) registres survient, le circuit de contrôle (603) traite cet accès dans lesdits registres.

9. Système (700) selon l'une quelconque des revendications 1 à 4, comportant en outre des première (MEM1) et deuxième (MEM2) mémoires tampons adaptées à mémoriser chacune le contenu d'une portion (401j ; S_{i,j}) de la mémoire résistive non volatile.

10. Système (700) selon la revendication 9, comportant en outre des première (t1') et deuxième (t2') tables adaptées à mémoriser chacune autant d'entrées de 1 bit qu'une portion (401ⱼ ; S_{i,j}) de la mémoire résistive non volatile comporte de pages (P_{i,j,k}).

11. Système (700) selon la revendication 9 ou 10, dans lequel lorsque des données sont déplacées dans la mémoire résistive non volatile par le circuit de contrôle (603) dans le cadre du procédé de gestion d'usure, ces données transitent par les première (MEM1) et/ou deuxième (MEM2) mémoires tampons, et, lorsqu'un accès utilisateur visant des données contenues dans les première (MEM1) et/ou deuxième (MEM2) mémoires survient, le circuit de contrôle (703) traite cet accès dans lesdites première et deuxième mémoires.

12. Système (600 ; 700) selon l'une quelconque des revendications 1 à 11, comportant en outre un dispositif (300) adapté à convertir des adresses logiques (301), qui sont les adresses utilisées par l'utilisateur pour accéder au contenu de la mémoire résistive non volatile, en adresses physiques (301'), qui sont les adresses où sont effectivement mémorisés les contenus visés par l'utilisateur dans la mémoire résistive non volatile.

13. Système (600 ; 700) selon la revendication 12, dans lequel le dispositif (300) de conversion d'adresses comprend, pour chaque portion (401ⱼ ; S_{i,j}) de la mémoire résistive non volatile, un compteur ou registre de suivi de décalages de pages (P_{i,j,k}) à l'intérieur de la portion.

14. Système (600 ; 700) selon l'une quelconque des revendications 1 à 13, comportant un dispositif de brouillage, au moyen d'une clé de cryptage, des adresses utilisées par l'utilisateur pour accéder au contenu de la mémoire résistive non volatile.

15. Système (600 ; 700) selon la revendication 2, dans lequel les déplacements de données du procédé d'équilibrage d'usure sont des déplacements internes aux portions de mémoire résistive non volatile (401ⱼ ; S_{i,j}), ou des déplacements entre des portions de mémoire résistive non volatile (401ⱼ ; S_{i,j}) distinctes.

16. Système (600 ; 700) selon l'une quelconque des revendications 1 à 15, dans lequel le procédé de gestion d'usure comprend un procédé de mesure d'usure comportant :
une première étape de lecture d'une page (P_{i,j,k}) dont on souhaite mesurer l'usure ;
une deuxième étape de lecture de ladite page (P_{i,j,k}) avec un seuil de discrimination entre les valeurs binaires '0' et '1' modifié par rapport à la première étape ; et
une étape de comparaison bit à bit des valeurs lues lors des première et deuxième étapes de lecture.

17. Système (600 ; 700) selon l'une quelconque des revendications 1 à 16, dans lequel la mémoire résistive non volatile comprend une pluralité de cellules, chaque cellule état adaptée à être programmée dans un état fortement résistif et dans un état faiblement résistif, dans lequel le procédé de gestion d'usure comprend un procédé de réparation d'usure consistant à écrire et effacer alternativement une pluralité de fois une cellule mémoire jugée défectueuse, et/ou à réinitialiser cette cellule en lui appliquant une tension de même polarité qu'une tension normalement utilisée pour programmer cette cellule à l'état faiblement résistif, mais de valeur supérieure.

## Patentansprüche

1. Ein System (600; 700), das Folgendes aufweist:
einen nichtflüchtigen resistiven Speicher (400; 500; 601), der eine Vielzahl von Abschnitten (401ⱼ; Si_{,}j) mit jeweils einer Vielzahl von Seiten (P_{i,j,k}) aufweist, wobei
der Speicher einen ersten (PT1) und einen zweiten (PT2) Anschluss aufweist, die einen gleichzeitigen Zugriff auf zwei Seiten des Speichers ermöglichen sofern diese Seiten zu verschiedenen Abschnitten des nichtflüchtigen resistiven Speichers gehören, wobei jeder der Abschnitte (401ⱼ; S_{i,j}) einen einzelnen Anschluss (A, dᵢₙ, dₒᵤₜ) für den Zugriff auf die Seiten in dem Abschnitt aufweist, wobei der Anschluss mit dem einen oder dem anderen der ersten (PT1) und zweiten (PT2) Anschlüsse des nichtflüchtigen resistiven Speichers über Multiplexschaltungen (405ⱼ, 407ⱼ, MUX1, MUX2; S1ⱼ, S2ⱼ) verbunden werden kann; und
eine Steuerschaltung (603; 703), die in der Lage ist, über den zweiten Anschluss (PT2) ein Managementverfahren für die Abnutzung des nichtflüchtigen resistiven Speichers (400; 500; 601) zu implementieren, das Lese- und/oder Schreibzugriffe auf in dem nichtflüchtigen resistiven Speicher gespeicherte Daten aufweist, indem gleichzeitig Nutzerzugriffe auf den Inhalt des nichtflüchtigen resistiven Speichers über den ersten Anschluss (PT1) zugelassen werden, wobei die Steuerschaltung (603; 703) in der Lage ist, einen Zugriff auf einen Abschnitt (401ⱼ; S_{i,j}) des nichtflüchtigen resistiven Speichers für das Managementverfahren für die Abnutzung nur dann durchzuführen, wenn kein Nutzerzugriff auf diesen Abschnitt des nicht-flüchtigen resistiven Speichers durchgeführt wird
**dadurch gekennzeichnet, dass** die Steuerschaltung (603; 703) in der Lage ist, von einem Taktgeber getaktet zu werden, der eine höhere Frequenz als die des nichtflüchtigen resistiven Speichers hat, wobei Nutzerzugriffe bei jedem Taktzyklus der Steuerschaltung durchgeführt werden können, und dass sie einen Zugriff auf einen Abschnitt (401ⱼ; S_{i,j}) des nichtflüchtigen resistiven Speichers für das Managementverfahren für die Abnutzung nur dann durchführt, wenn gleichzeitig ein Nutzerzugriff auf einen anderen Abschnitt des nichtflüchtigen resistiven Speichers durchgeführt wird.

2. System (600; 700) nach Anspruch 1, wobei das Managementverfahren für die Abnutzung ein Abnutzungsausgleichsverfahren ist, das Datenverschiebungen aufweist, die zu einer Modifizierung der physischen Adresse der Daten innerhalb des nichtflüchtigen resistiven Speichers führen.

3. System (600; 700) nach Anspruch 1 oder 2, wobei die Steuerschaltung (603; 703) in der Lage ist, Nutzerzugriffe auf den Inhalt des nichtflüchtigen resistiven Speichers vorrangig vor Zugriffen des Managementverfahren für die Abnutzung zu verarbeiten.

4. System (600; 700) nach einem der Ansprüche 1 bis 3, wobei die Steuerschaltung (603; 703) in der Lage ist, einen Schreibzugriff auf einen Abschnitt (401ⱼ; S_{i,j}) des nichtflüchtigen resistiven Speichers für das Managementverfahren für die Abnutzung nur dann durchzuführen, wenn ein Nutzerschreibzugriff auf einen anderen Abschnitt des nichtflüchtigen resistiven Speichers durchgeführt wird.

5. System (600; 700) nach einem der Ansprüche 1 bis 4, wobei die Steuerschaltung (603; 703) in der Lage ist, einen Lesezugriff auf einen Abschnitt (401ⱼ; S_{i,j}) des nichtflüchtigen resistiven Speichers für das Managementverfahren für die Abnutzung nur dann durchzuführen, wenn ein Nutzerlesezugriff auf einen anderen Abschnitt des nichtflüchtigen resistiven Speichers durchgeführt wird.

6. System (600) nach einem der Ansprüche 1 bis 5, das weiterhin ein erstes (REGA) und ein zweites (REGB) Register aufweist, die jeweils den Inhalt einer Seite (M_{i,j,k,l}) des nichtflüchtigen resistiven Speichers speichern können.

7. System (600) nach Anspruch 6, das weiterhin erste (t1) und zweite (t2) Tabellen aufweist, die jeweils so viele 2-Bit-Einträge speichern können, wie ein Abschnitt (401ⱼ; S_{i,j}) des nichtflüchtigen resistiven Speichers Seiten (P_{i,j,k}) aufweist.

8. System (600) nach Anspruch 6 oder 7, wobei, wenn Daten in dem nichtflüchtigen resistiven Speicher durch die Steuerschaltung (603) im Rahmen des Managementverfahren für die Abnutzung verschoben werden, die Daten die ersten (REGA) und/oder zweiten (REGB) Register durchlaufen und, wenn ein Nutzerzugriff, der auf Daten abzielt, die in den ersten (REGA) und/oder zweiten (REGB) Registern enthalten sind, erfolgt, die Steuerschaltung (603) diesen Zugriff in den genannten Registern verarbeitet.

9. System (700) nach einem der Ansprüche 1 bis 4, das ferner einen ersten (MEM1) und einen zweiten (MEM2) Pufferspeicher aufweist, die jeweils den Inhalt eines Abschnitts (401ⱼ; S_{i,j}) des nichtflüchtigen resistiven Speichers speichern können.

10. System (700) nach Anspruch 9, das weiterhin erste (t1') und zweite (t2') Tabellen aufweist, die in der Lage sind, jeweils so viele 1-Bit-Einträge zu speichern, wie ein Abschnitt (401ⱼ; S_{i,j}) des nicht-flüchtigen resistiven Speichers Seiten (Pi,j,k) aufweist.

11. System (700) nach Anspruch 9 oder 10, wobei, wenn Daten in dem nichtflüchtigen resistiven Speicher durch die Steuerschaltung (603) im Rahmen des Managementverfahren für die Abnutzung verschoben werden, die Daten den ersten (MEM1) und/oder zweiten (MEM2) Pufferspeicher durchlaufen und, wenn ein Nutzerzugriff, der auf Daten abzielt, die in dem ersten (MEM1) und/oder zweiten (MEM2) Speicher enthalten sind, erfolgt, die Steuerschaltung (703) diesen Zugriff in dem ersten und zweiten Speicher verarbeitet.

12. System (600; 700) nach einem der Ansprüche 1 bis 11, ferner aufweisend eine Vorrichtung (300), die in der Lage ist, logische Adressen (301), die die vom Nutzer für den Zugriff auf den Inhalt des nichtflüchtigen resistiven Speichers verwendeten Adressen sind, in physische Adressen (301') umzuwandeln, die die Adressen sind, an denen die vom Nutzer im nichtflüchtigen resistiven Speicher anvisierten Inhalte tatsächlich gespeichert sind.

13. System (600; 700) nach Anspruch 12, wobei die Adressumwandlungsvorrichtung (300) für jeden Abschnitt (401ⱼ; Sᵢ,ⱼ) des nichtflüchtigen resistiven Speichers einen Zähler oder ein Register zum Verfolgen der Verschiebungen von Seiten (P_{i,j,k}) innerhalb des Abschnitts aufweist.

14. System (600; 700) nach einem der Ansprüche 1 bis 13, das eine Vorrichtung zum Verschlüsseln von Adressen aufweist, die vom Nutzer für den Zugriff auf den Inhalt des nichtflüchtigen resistiven Speichers verwendet werden, mit Hilfe eines Verschlüsselungsschlüssels.

15. System (600; 700) nach Anspruch 2, wobei die Datenverschiebungen des Abnutzungsausgleichsverfahren Verschiebungen innerhalb der Abschnitte (401ⱼ; S_{i,j}) des nichtflüchtigen resistiven Speichers oder Verschiebungen zwischen verschiedenen Abschnitten (401ⱼ; S_{i,j}) des nichtflüchtigen resistiven Speichers sind.

16. System (600; 700) nach einem der Ansprüche 1 bis 15, wobei das Managementverfahren für die Abnutzung ein Abnutzungsmessverfahren aufweist, das Folgendes aufweist:
einen ersten Schritt des Auslesens einer Seite (P_{i,j,k}), deren Abnutzung gemessen werden soll;
einen zweiten Schritt des Lesens der Seite (P_{i,j,k}) mit einem Unterscheidungsschwellenwert zwischen binären Werten "0" und "1", der in Bezug auf den ersten Schritt modifiziert ist; und
einen Schritt des Bit-zu-Bit-Vergleichs der während des ersten und zweiten Leseschritts gelesenen Werte.

17. System (600; 700) nach einem der Ansprüche 1 bis 16, wobei der nichtflüchtige resistiven Speicher eine Vielzahl von Zellen aufweist, wobei jede Zelle in einen hoch resistiven Zustand und in einen nieder resistiven Zustand programmiert werden kann, wobei das Managementverfahren für die Abnutzung ein Abnutzungsreparaturverfahren aufweist, das ein mehrmaliges abwechselndes Schreiben und Löschen in eine und aus einer als defekt erachteten Speicherzelle aufweist und/oder ein Zurücksetzen dieser Zelle durch Anlegen einer Spannung mit derselben Vorspannung wie eine Spannung, die normalerweise verwendet wird, um diese Zelle in den nieder resistiven Zustand zu programmieren, aber mit einem größeren Wert.

## Claims

1. A system (600; 700) comprising:
a non-volatile resistive memory (400; 500; 601) comprising a plurality of portions (401ⱼ; S_{i,j}) of a plurality of pages (P_{i,j,k}) each, the memory comprising first (PT1) and second (PT2) ports enabling to simultaneously access two pages of the memory, provided that these pages belong to different portions of the non-volatile resistive memory, each of said portions (401ⱼ; S_{i,j}) comprising a single port (A, dᵢₙ, dₒᵤₜ) of access to the pages in the portion, where the port can be connected to one or the other of the first (PT1) and second (PT2) ports of the non-volatile resistive memory via multiplexing circuits (405ⱼ, 407ⱼ, MUX1, MUX2; S1ⱼ, S2ⱼ); and
a control circuit (603; 703) capable of implementing, via the second port (PT2), a method of managing the wear of the non-volatile resistive memory (400; 500; 601) comprising read and/or write accesses to data stored in the non-volatile resistive memory, by simultaneously allowing user accesses to the non-volatile resistive memory content via the first port (PT1), the control circuit (603; 703) being capable of performing an access to a portion (401ⱼ; S_{i,j}) of the non-volatile resistive memory for the wear management method only when no user access is being performed on this portion of the non-volatile resistive memory,
**characterized in that** the control circuit (603; 703) is capable of being clocked by a clock having a frequency higher than that of the non-volatile resistive memory and **in that** user accesses can be performed at any clock cycle of the control circuit, and of only performing an access to a portion (401ⱼ; S_{i,j}) of the non-volatile resistive memory for the wear management method when a user access is being performed simultaneously on another portion of the non-volatile resistive memory.

2. The system (600; 700) of claim 1, wherein said wear management method is a wear balancing method comprising data displacements resulting in modifying the physical address of the data within the non-volatile resistive memory.

3. The system (600; 700) of claim 1 or 2, wherein the control circuit (603; 703) is capable of processing in priority user accesses to the content of the non-volatile resistive memory over accesses of the wear management method.

4. The system (600; 700) of any of claims 1 to 3, wherein the control circuit (603; 703) is capable of only performing a write access to a portion (401ⱼ; S_{i,j}) of the non-volatile resistive memory for the wear management method when a user write access is being performed on another portion of the non-volatile resistive memory.

5. The system (600; 700) of any of claims 1 to 4, wherein the control circuit (603; 703) is capable of only performing a read access to a portion (401ⱼ; S_{i,j}) of the non-volatile resistive memory for the wear management method when a user read access is being performed on another portion of the non-volatile resistive memory.

6. The system (600) of any of claims 1 to 5, further comprising first (REGA) and second (REGB) registers capable of each storing the content of a page (M_{i,j,k,l}) of the non-volatile resistive memory.

7. The system (600) of claim 6, further comprising first (t1) and second (t2) tables capable of each storing as many 2-bit entries as a portion (401ⱼ; S_{i,j}) of the non-volatile resistive memory comprises pages (P_{i,j,k}).

8. The system (600) of claim 6 or 7, wherein, when data are displaced in the non-volatile resistive memory by the control circuit (603) in the context of the wear management method, the data transit through the first (REGA) and/or second (REGB) registers and, when a user access targeting data contained in the first (REGA) and/or second (REGB) registers occurs, the control circuit (603) processes this access in said registers.

9. The system (700) of any of claims 1 to 4, further comprising first (MEM1) and second (MEM2) buffer memories capable of each storing the content of a portion (401ⱼ; S_{i,j}) of the non-volatile resistive memory.

10. The system (700) of claim 9, further comprising first (t1') and second (t2') tables capable of each storing as many 1-bit entries as a portion (401ⱼ; S_{i,j}) of the non-volatile resistive memory comprises pages (P_{i,j,k}).

11. The system (700) of claim 9 or 10, wherein, when data are displaced in the non-volatile resistive memory by the control circuit (603) in the context of the wear management method, the data transit through the first (MEM1) and/or second (MEM2) buffer memories and, when a user access targeting data contained in the first (MEM1) and/or second (MEM2) memories occurs, the control circuit (703) processes this access in said first and second memories.

12. The system (600; 700) of any of claims 1 to 11, further comprising a device (300) capable of converting logic addresses (301), which are the addresses used by the user to access the content of the non-volatile resistive memory, into physical addresses (301'), which are the addresses where the contents targeted by the user in the non-volatile resistive memory are effectively stored.

13. The system (600; 700) of claim 12, wherein the address conversion device (300) comprises, for each portion (401ⱼ; S_{i,j}) of the non-volatile resistive memory, a counter or register for tracking the shifts of pages (P_{i,j,k}) within the portion.

14. The system (600; 700) of any of claims 1 to 13, comprises a device for scrambling, by means of an encryption key, addresses used by the user to access the content of the non-volatile resistive memory.

15. The system (600; 700) of claim 2, wherein the data displacements of the wear balancing method are displacements internal to the portions (401ⱼ; S_{i,j}) of the non-volatile resistive memory, or displacements between different portions (401ⱼ; S_{i,j}) of the non-volatile resistive memory.

16. The system (600; 700) of any of claims 1 to 15, wherein the wear management method comprises a wear measurement method comprising:
a first step of reading from a page (P_{i,j,k}), the wear of which is desired to be measured;
a second step of reading said page (P_{i,j,k}) with a threshold of discrimination between binary values '0' and '1' modified with respect to the first step; and
a step of bit-to-bit comparison of the values read during the first and second reading steps.

17. The system (600; 700) of any of claims 1 to 16, wherein the non-volatile resistive memory comprises a plurality of cells, each cell being capable of being programmed in a high resistive state and in a low resistive state, wherein the wear management method comprises a wear repair method comprising alternately writing and deleting, a plurality of times, into and from a memory cell deemed defective, and/or resetting this cell by applying thereto a voltage of same polarity as a voltage normally used to program this cell to the low resistive state, but of greater value.
